# EUROPEAN PATENT SPECIFICATION

(11) **EP 3 997 437 B1**
(45) Date of publication and mention of the grant of the patent: **01.04.2026**
(21) Application number: 20840201.6
(22) Date of filing: 10.07.2020
(51) Int. Cl.: G01N 3/08, G01N 3/06, G06N 20/00, G06F 30/17, G06N 3/04, G06N 3/08, G06N 5/00, G06F 30/27, G05B 13/02

(54) **MACHINE-LEARNING-BASED ASSESSMENT FOR ENGINEERED RESIDUAL STRESS PROCESSING**
AUF MASCHINENLERNEN BASIERENDE BEWERTUNG FÜR TECHNISCHE RESTSPANNUNGSVERARBEITUNG
ÉVALUATION BASÉE SUR L'APPRENTISSAGE MACHINE POUR LE TRAITEMENT DE CONTRAINTES RÉSIDUELLES MODIFIÉES

(30) Priority: 12.07.2019 US 201962873735 P; 03.12.2019 US 201962942941 P
(43) Date of publication of application: 18.05.2022
(73) Proprietor: Fatigue Technology, Inc., Seattle, WA 98188 (US)
(72) Inventor: ZIMMERMAN, Samuel, Seattle, WA 98188 (US)
(74) Representative: Murgitroyd & Company
(86) International application number: PCT/US2020/041631
(87) International publication number: WO 2021/011385

(56) References cited:
- WO-A1-2019/136001
- US-A1- 2006 075 827
- US-A1- 2013 200 543
- US-A1- 2017 270 434
- US-A1- 2018 260 720
- US-A1- 2018 307 198
- US-B2- 10 295 475
- RIBEIRO RENAN L., HILL MICHAEL R.: "Residual Stress From Cold Expansion of Fastener Holes: Measurement, Eigenstrain, and Process Finite Element Modeling", JOURNAL OF ENGINEERING MATERIALS AND TECHNOLOGY., THE AMERICAN SOCIETY OF MECHANICAL ENGINEERS, US, vol. 139, no. 4, 1 October 2017 (2017-10-01), US, XP055774098, ISSN: 0094-4289, DOI: 10.1115/1.4037021

## Description

### Field

This disclosure generally relates to mechanical processing of materials and, more particularly, to monitoring and inspection of cold-expanded holes with computational performance assessment.

### Description of the Related Art

In the construction of durable mechanical assemblies, a primary threat to structural integrity is fatigue cracking in metallic structures. Engineered residual stress (ERS) is a proven manufacturing technique for increasing the strength of materials at critical locations such as joints. In principle, residual stresses are stresses that remain in a solid material after the original cause of the stresses has been removed. A material having compressive residual stress helps to prevent brittle fracture because the initial crack is formed under compressive stress. Advantageously, in these materials, for any cracks to propagate due to external tensile stress, the external tensile stress must overcome the compressive residual stress before the crack tips experience sufficient tensile stress to propagate.

Split-sleeve hole cold expansion (Cx) is a type of technique for imparting ERS in a metal structure to significantly increase the fatigue life of the structure. According to one known Cx technique, conventional installation tools are used to install bushings in holes within workpieces. These installation tools typically have an expansion mandrel with an enlarged tapered portion used to expand the bushing. To radially expand the bushing, the expansion mandrel is inserted into an opening in the bushing. The bushing and mandrel are simultaneously inserted into a hole in a workpiece, and the enlarged tapered portion of the mandrel is forcibly pulled axially through the opening of the bushing until an interference fit is formed between the bushing and workpiece. Split-sleeve Cx achieves fatigue life improvement by inducing a beneficial ERS field at the hole.

It would be advantageous if the Cx process could be verified. However, post-process verification is difficult and expensive. Residual stress is difficult to measure, and therefore it is difficult to quantify the magnitude and depth of the ERS Field.

US 2013/0200543 A1 relates to a processing system which employs a processing tool to process workpieces. US2017270434A1 discloses a machine learning apparatus that learns laser machining condition data.

### BRIEF SUMMARY

According to some aspects of the embodiments, a hole cold expansion tool system is provided that monitors the key parameters developed during the cold expansion process. Improving on an all-in-one cold hole expansion processing tool that uses collected data to provide enhanced quality control and verification of the expansion process, one of the solutions described herein is directed to real-time evaluation of the quality of the hole cold expansion imparted to the part by processing the measured hydraulic pressure and piston location. This quality control procedure provides additional confidence in the hole cold expansion processing event, and can reduce the uncertainty in the resulting residual stress. Data processing and analysis techniques are described that are used to quantify the hole cold expansion quality.

Using real-time data processing techniques to analyze the presented data quickly and efficiently, a "go/no-go" system according to some embodiments is capable of differentiating between holes that do, and holes that do not, meet any given industry specification. This system is compatible with multiple specification systems, geometry conditions, and material types. In related embodiments, the system has multiple calibration levels, allowing the end user to determine the appropriate level of investment for the required statistical fidelity.

Aspects of the embodiments improve upon hole cold working techniques by integrating real-time process monitoring and verification. This data-driven solution provides increased confidence in the effectiveness and totality of the structure processing, as well as provides traceable, archival data records for each cold worked hole. In some applications, such as airframe structural engineering and fabrication, manufacturers can leverage this increased confidence to realize increased airframe service life credit while reducing inspection interval costs to the maintainer.

An instrumented technique may be employed as a material-processing quality check. In some examples, an instrumented technique utilizes force sensing during hole expansion or other material-processing operations. Automation of tracking of processing operations and sensed conditions may provide numerous benefits. For example, such may allow a record to be created of every installation, for example on a hole-by-hole basis, or workpiece-by-workpiece basis. Such can be used to demonstrate that, for example, cold working has been performed, and even that an acceptable level of cold working has been achieved. Such not only documents the process, but provides proof of performance and even allows assessment of quality of performance.

The tracking may allow higher quality assurance and a consequent loosening in acceptable manufacturing tolerances. For example, such may allow tolerance of holes to be loosened from for example .001 inch to .002 inch. Such may in turn reduce production costs, and parts costs. Tracking may also allow identification of problems in the manufacturing process, including process protocol, early identification out of compliance materials, and even identification of individual performance or other training issues. Such may also be used to separate variation in user or operator performance from variation in materials and/or tool performance.

Information from the processing may be captured and stored for later validation or review of an installation process, as well as the material properties of the materials employed, such as primary and secondary workpieces. Also for example, tracking and related information from the processing may be employed in dynamically controlling operation of the processing tool. For instance, the performance of various processing operations may be modified or adjusted based on captured information regarding the processing, including information about the specific characteristics of the particular materials. Detection of out of compliance materials or operations may cause a stop in the processing, allowing correction or preventing further time and resources being applied to a workpiece that cannot be used.

Accordingly there is provided a method as detailed in claim 1. Advantageous features are in the dependent claims. A non-transitory machine-readable medium, a system and a network for performing the method are also provided.

### BRIEF DESCRIPTION OF THE SEVERAL VIEWS OF THE DRAWINGS

In the drawings, identical reference numbers identify similar elements or acts. The sizes and relative positions of elements in the drawings are not necessarily drawn to scale. For example, the shapes of various elements and angles are not drawn to scale, and some of these elements are arbitrarily enlarged and positioned to improve drawing legibility. Further, the particular shapes of the elements as drawn, are not intended to convey any information regarding the actual shape of the particular elements, and have been solely selected for ease of recognition in the drawings.
Fig. 1 is an environmental view of a processing system positioned with respect to a portion of a primary workpiece to install an expandable member such as bushing, nut plate or grommet in a hole in the primary workpiece, the processing system including a processing tool, an expansion assembly, a processor-based subsystem, and optionally a pressurization system, according to one illustrated embodiment.
Fig. 2A is a partial sectional view of the processing tool and expansion assembly of Fig. 1 according to one implementation, particularly illustrating a piston of the processing tool, a core element of the expansion assembly, and a number of sensors of the processing tool that sense various operational conditions or characteristics of the processing tool and/or expansion assembly.

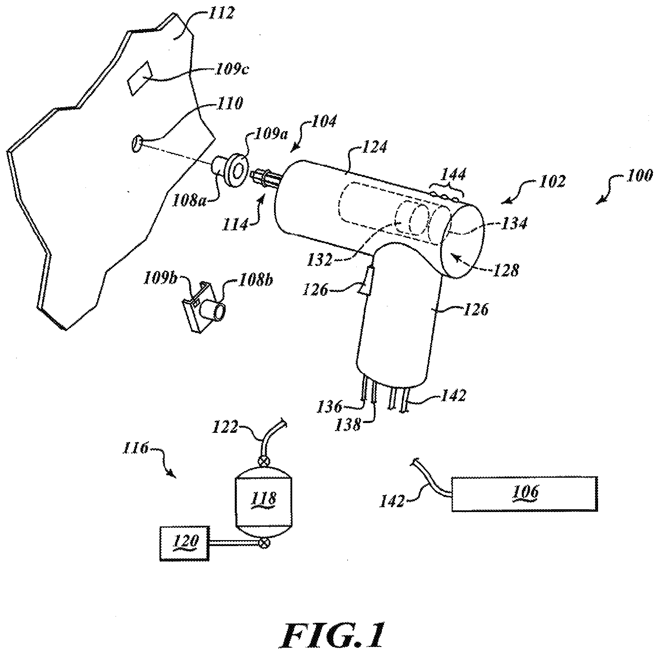

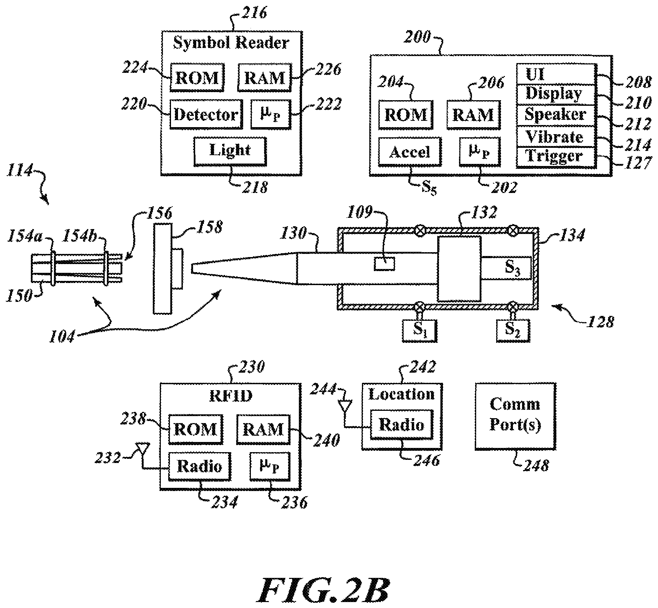

Fig. 2B is a partial sectional view of the processing tool and expansion assembly of Fig. 1 according to another implementation, particularly illustrating a piston of the processing tool, a core element of the expansion assembly, a number of sensors of the processing tool that sense various operational conditions or characteristics of the processing tool and/or expansion assembly, and a number of optional subsystems of the processing tool including a control subsystem, a machine-readable symbol reader subsystem, a radio frequency identification (RFID) interrogation subsystem, a spatial location subsystem, and communications subsystem.
Fig. 3 is an isometric environmental view of a number of the processing systems of Fig. 1 in use on a portion of a primary workpiece, each communicatively coupled with a host computer system such as a server computer system, and illustrating a spatial location network to facilitate spatially locating respective ones of the processing tools in the environment.
Fig. 4 is a schematic diagram of a processing system including a processing tool and processor-based controller, communicatively coupled to a host computer system via a network, according to one illustrated embodiment, communicatively coupled to at least one of the processing tools.
Fig. 5 is a plot or graph of pressure versus position of a drive member of a processing tool, accordingly to one illustrated embodiment, showing a sensed or measured response relationship.
Fig. 6 is a flow diagram of a high level method of operating a processing system, accordingly to one illustrated embodiment.
Fig. 7 is a flow diagram of a method of dynamically operating a processing tool of a processing system, accordingly to one illustrated embodiment.
Fig. 8 is a flow diagram of a method of operating a processing system to sense parameters or conditions, accordingly to one illustrated embodiment, which may be useful in performing the method of Fig. 7.
Fig. 9 is a system block diagram illustrating a machine-learning-based assessment system for determining whether individual material-processing operations were completed within the applicable specification, according to an example embodiment.
Fig. 10 is a diagram illustrating an example architecture of a deep neural network that may be used to implement a trained deep neural network as depicted in the example embodiment of Fig. 9.
Fig. 11 is a flow diagram illustrating an example process of operation of a deep neural network for assessment of material-processing operations according to some embodiments.
Fig. 12 is a flow diagram illustrating an example process of training a deep neural network for a use with material-processing operations according to some embodiments.
Fig. 13 is a system block diagram illustrating a machine-learning-based assessment system for predicting fatigue life of materials having been cold-worked with material-processing operations according to a related type of embodiment.
Fig. 14A is a graph that illustrates an example of a residual stress profile as a 2-dimensional plot.
Fig. 14B is a graph that illustrates a plot exemplifying an applied stress profile in terms of hoop stress versus distance from the hole bore.
FIG. 14C is a chart that shows an example set of material properties data. These data types may be provided as inputs to the system depicted in Fig. 13 according to an illustrative embodiment.
Fig. 15 is a diagram illustrating an example architecture of a deep neural network that may be used to implement a trained deep neural network as depicted in Fig. 13, for example.
Fig. 16 is a flow diagram illustrating an example process of operation of a deep neural network for estimation of fatigue life of a workpiece following material-processing operations according to some embodiments.
Fig. 17 is a system block diagram illustrating a machine-learning-based assessment system operative to evaluate received measurement data using a decision tree, according to another type of embodiment.
FIG. 18 is a diagram illustrating an example decision tree classifier that may be implemented by a decision tree engine of the machine-learning-based assessment system of Fig. 17.
FIG. 19 is a process flow diagram illustrating an example process of operation of a tree-based evaluation system according to some embodiments.

### DETAILED DESCRIPTION OF THE EMBODIMENTS

In the following description, certain specific details are set forth in order to provide a thorough understanding of various embodiments. However, one skilled in the art will understand that the subject matter described may be practiced without these details.

Unless the context requires otherwise, throughout the specification and claims which follow, the word "comprise" and variations thereof, such as, "comprises" and "comprising" are to be construed in an open, inclusive sense, that is as "including, but not limited to."

The headings provided herein are for convenience only and do not interpret the scope of meaning of the claimed invention. The following description relates to installation/processing systems used to install expandable members (e.g., tubular bushings, rivetless nut plates, grommets, fittings, sleeves, etc.) in openings, such as non-through holes in workpieces. The systems can also be used to process workpieces, such as cold working holes in workpieces, with or without installation of an expandable member therein. For purposes of this discussion and for clarity, a material-processing system for installing an expandable member will be described, and then a description of its components will follow. The term "material-processing system" is a broad term and includes, without limitation, a system that can be used to expand an expandable member, material surrounding a hole in a workpiece, or other suitable expandable structures. In some embodiments, processing systems are installation systems that install expandable members in workpieces. The material-processing systems can also be in the form of cold expansion systems used to cold expand holes in workpieces, either with or with installing an expandable member. The terms "proximal" and "distal" are used to describe the illustrated embodiments and are used consistently with a description of non-limiting exemplary applications. The terms "proximal" and "distal" are used in reference to the user's body when the user operates a processing system, unless the context clearly indicates otherwise. It will be appreciated, however, that the illustrated embodiments can be located or oriented in a variety of desired positions.

As noted above, the material-processing system can be used in material-processing operations involving workpieces. As used herein, the term "primary workpiece" or sometimes just "workpiece" is broadly construed to include, without limitation, a parent structure having at least one hole or opening suitable for processing (e.g., receiving an expandable member, undergoing cold expansion, etc.). The hole can be, for example, a through hole, non-through hole, blind hole, counter bore, or other types of holes that may or may not have backside access. In some embodiments, the primary workpiece is a bulkhead, fuselage, engine or other structural member of an aircraft, even if there is limited or no backside access. In some embodiments, the primary workpiece itself may be suitable for expansion (e.g., cold expansion) and may or may not be suitable for receiving an expandable member.

### Overview of Material Processing System

Fig. 1 shows a material-processing system 100 including a processing tool 102, an expansion assembly 104 physically coupled to the processing tool 102, and a processor-based controller 106 communicatively coupled to the processing tool 102, according to one illustrated embodiment. Generally, the illustrated material-processing system 100 may be used for one-sided or two-sided installation of an expandable member such as a bushing 108a or rivetless nut plate 108b (generically expandable member 108) in hole 110 in a primary workpiece 112. A selectively expandable portion 114 of the expansion assembly 104 can be controllably expanded in order to expand and install the expandable member 108. After installation, the expandable portion 114 can be controllably contracted to separate the expansion assembly 104 from the installed expandable member 108 (shown in Fig. 1 prior to installation). The expandable member 108 is sometimes referred to herein as a secondary workpiece, since processing may be performed in the expandable member in installing the expandable member at least partially in the hole 110 of the primary workpiece 112.

As noted above, the material-processing system 100 (Fig. 1) can be used in procedures involving workpieces. As used herein, the term "primary workpiece" or sometimes just "workpiece" is broadly construed to include, without limitation, a parent structure having at least one hole or opening suitable for processing (e.g., receiving an expandable member, undergoing cold expansion, etc.). The hole can be, for example, a through hole, non-through hole, blind hole, counter bore, or other types of holes that may or may not have backside access. In some embodiments, the primary workpiece is a bulkhead, fuselage, engine or other structural member of an aircraft, even if there is limited or no backside access. In some embodiments, the primary workpiece itself may be suitable for expansion (e.g., cold expansion) and may or may not be suitable for receiving an expandable member.

The processing tool 102 can be driven electrically, hydraulically, pneumatically, or by any other suitable drive structures, mechanisms or engines. For example, the processing tool 102 may be fluidly communicatively coupled to a pressurization system 116 which includes a source of pressurized fluid, for instance one or more hydraulic reservoirs 118 (only one illustrated) and/or pumps 120 (only one illustrated) via a distribution system such as a hydraulic distribution system 122 including one or more fluid carrying conduits, valves, and/or manifolds. The pressurization system may be of any conventional design, thus is not described in detail in the interest of brevity. Notably, other sources of power or drive capable of producing the required or desired forces may be employed.

The illustrated processing tool 102 includes a main body 124 that is coupled to a grip 126. The user can manually grasp the grip 126 to controllably hold and accurately position the processing tool 102 with respect to the primary workpiece 112. The grip 126 is illustrated as a pistol grip, however, other types of grips can be utilized. Where in the form of a handheld device, the processing tool 102 may include a trigger 127, for example a rocker switch, momentary contact switch or other switch to activate the processing tool 102.

The illustrated processing tool 102 may include a second user operative button, key, switch or trigger 129, referred to herein as mode switch 129. The mode switch 129 may be operative for selectively changing a mode of operation of the processing tool 102. For example, an operator or end user may sequentially cycle or toggle through two or more modes of operation by selectively actuating the mode switch 129. Modes may, for example, include lube priming mode, operational cycle mode, error state mode.

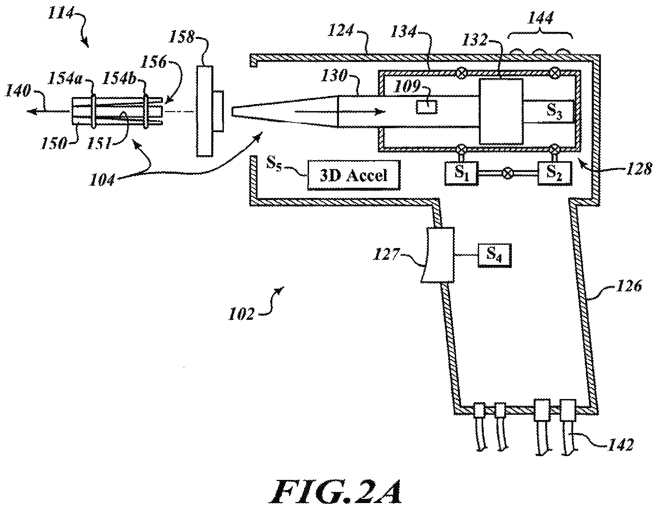

The main body 124 houses a drive system 128 (shown in broken line in Fig. 1) that can drive a mandrel or core element 130 (Fig. 2A), 130 (Fig. 2B) (generically 130) of the expansion assembly 104 with respect to the expandable portion 114 of the expansion assembly 104. The drive system 128 can have a push/pull piston arrangement and may comprise a double acting piston 132 and hydraulic cylinder 134. Other cylinder arrangements are also possible.

A pair of fluid conduits or lines 136, 138 can provide pressurized fluid (e.g., pressurized gas, liquid, or combinations thereof) to the drive system 115 and/or relieve pressurized fluid from the drive system 128. For example, if the drive system 115 comprises a hydraulic piston arrangement, the fluid lines 136, 138 can provide pressurized hydraulic fluid.

The drive system 128 of Figures 2A and 2B can be activated to drive the core element 130 along a predetermined path. The predetermined path can be a generally linear path (e.g., a line of action) extending in a proximal and a distal direction. For example, the illustrated drive system 128 reciprocates or translates the core element 130 distally and proximally along a predetermined path represented by double headed arrow 140 (Fig. 2A).

A set of wires or a wire bundle 142 can provide wired communications between the processing tool 102 and the processor-based controller 106. Communications may be implemented via a controller-area network (CAN) bus using defined CAN bus protocols. Alternatively, wireless communications may be employed via one or more wireless transmitters, receivers, transceivers, or radios. As described in more detail herein, the communications may include the transmission of data or information sensed, measured or otherwise determined by one or more sensors of the processor tool 102 to the processor-based controller 106, which may be stored and/or analyzed. Also as described in more detail herein, the communications may include the transmission of instructions or commands, with or without data to the processor tool 102 from the processor-based controller 106, to control operation of the processor tool 102. **In** some less preferred embodiments, signaling (e.g., triggering) may be achieved via changes in pressure of a fluid, for instance pneumatically or hydraulically.

Optionally, the processing tool 100 may include one or more visual indicators 144 that provide a visual indication of an operating condition or state of the processing tool 102. For example, one or more of the visual indications may indicate when a drive member or actuator has reached a full forward position, which may be a position calibrated using an optional adjustment collar 158. Visual indicators 144 may, for example, take the form of one or more light emitting diodes (LEDs), for example emitting respective colors *(e.g.,* Yellow, Green, Red) to indicated different conditions *(e.g.,* installing or inserting, paused or stopped, error, retracting or withdrawal). For instance, steady green may indicate that the tool is ready for performing a processing cycle (e.g., lubed). Yellow may indicate that a processing cycle is being performed. Yellow with a flashing green may indicate that the processing cycle has been successfully completed. Steady or flashing red may indicated that an error has occurred. LEDs may additionally or alternatively be flashed in various patterns to indicate various error codes. Additionally or alternatively, error messages may be displayed on a display, for example an LCD, for instance carried by the power unit to which the tool is coupled. LEDs are relatively robust, and hence may be desirable for use in tools which are subjected to harsh environments and working conditions including shocks and drops. Alternatively, visual indicators may take other forms, for instance one or more liquid crystal displays, although such tend to be less rugged than LEDs. Alternatively, where pressure is employed to supply control signals to a processing tool, an indicator may take a mechanical form, for example a popup indicator that has a signal member which pops up in response to full travel of the drive member being achieved.

The various elements or components (e.g., sensors, LEDs) may be powered and/or communicatively coupled via one or more buses or other structures. For example, such may be communicatively coupled to the wires or wire bundle 142. Such may be electrically coupled to on on-board power source *(e.g.,* secondary chemical battery, fuel cell, ultra-capacitor array).

As further illustrated in Fig. 1, one or more components or elements may include a unique identifier, which may be read by the material-processing system 100.

For example, an expandable member such as bushing 108a may have inscribed on, include, carry or bear a machine-readable symbol 109a such as a one dimensional machine-readable symbol *(i.e.,* barcode symbol) or two-dimensional machine-readable symbol (e.g., area or matrix code symbol) which encodes a unique identifier and is readable by a machine-readable symbol reader or subsystem. The machine-readable symbol 109a may, for example, be printed on a label and adhered to the bushing 108a on an appropriate surface thereof.

Also for example, an expandable member such as rivetless nut plate 108b may include, carry or bear a wireless transponder 109b such as a passive radio frequency identification (RFID) transponder or tag which encodes a unique identifier and/or other information that is readable by a reader such as an interrogator and/or writeable thereby. The wireless transponder 109b may, for example, be formed as a printed circuit trace antenna and integrated circuit component on a tag and adhered to the rivetless nut plate 108b on an appropriate surface thereof.

As another example, a primary workpiece 112 may include, carry or bear a combination machine-readable symbol and RFID transponder or tag 109c which encode a unique identifier and/or other information that is readable by a reader or interrogator and/or writeable thereby. The tag 109c may be adhered to the primary workpiece 112 on an appropriate surface thereof.

Also for example, the core element 130 and/or expandable portion 114 may include, carry or bear a wireless transponder such as a passive radio frequency identification (RFID) transponder or tag 109d (Figures 2A, 2B) which encodes a unique identifier and/or other information that is readable by an interrogator and/or writeable thereby. The wireless transponder 109d may, for example, be formed as a tag and adhered to the core element 130 and/or expandable portion 114 on an appropriate surface thereof. Alternatively, or additionally, the core element 130 and/or expandable portion 114 may include, carry or bear a machine-readable symbol.

In each of the above examples, use of a wireless transponder may provide advantages over machine-readable symbols, for example allowing storage of information, data or conditions after the transponder or tag is applied to the component. Such may also provide for non-line-of-sight reading. Various examples of operation advantageously employing wireless transponders and/or machine-readable symbols are described herein.

The processor-based controller 106 and the pressurization system 116 may be collocated, for example as power unit to which the tool 102 is coupled via hoses and cables. The power unit may be mounted to a frame (not shown), preferably a rugged tubular frame to provide protection to the various elements, particularly protection from the harsh environment and handling expected in typical manufacturing environments. The frame (not shown) may include a housing or shroud (not shown), again providing protection in a harsh environment. The frame (not shown) may include wheels (not shown). The frame (not shown) may include a handle (not shown), for example a telescoping handle, allowing the frame to be easily wheeled from location to location.

In use, pressing and holding the trigger 127 may cause the processing tool to perform a complete cycle of an operation, for instance a cold working radial expansion of a hole, with or without a fastener inserted in the hole. For example, when the processing tool is in a defined operational mode *(e.g.,* operational cycle mode), pressing and holding the trigger 127 may cause the processing tool to 1) extend a core element (e.g., mandrel) 130, expanding a selectively expandable portion 114 to radially expand a hole, 2) dwelling briefly in the expanded state, and 3) retract the core element 130, allowing the selectively expandable portion 114 to return to an expanded configuration. Completion of the full cycle may be indicated to the operator or user, for example via a visual indication (e.g., illumination of green LED) and/or an aural alert. Releasing the trigger 127 prior to completion of the full cycle may cause the core element 130 to retract early. Failure to complete the full cycle may be indicated to the operator or user, for example via a visual indication (e.g., illumination of red LED) and/or an aural alert. The operator or user advantageously only needs to pay attention to the indicators (e.g., LEDs) to determine whether a processing operation has been successfully completed and can move on to the next processing operation (e.g., next hole).

Fig. 2A shows the processing tool 102 and expansion assembly 104 of Fig. 1, according to one illustrated embodiment. Many of the structures and elements are similar or even identical to those of the implementation illustrated in Fig. 1, and are thus denominated using the same reference numbers as in Fig. 1 or the same reference numbers with a lower case letter "a" appended thereto.

As illustrated in Fig. 2A, the expansion assembly 104 may comprises a core element 130 and an expandable portion 114. The expandable portion 114 is physically coupled to a distal portion 122 of the processing tool 104, typically extending therefrom. The core element 130 is positioned to be driven by the drive system 128, and to physically interact with the expandable portion to expand and retract the expandable portion 114 in responsive to the core element 130 being driven by the drive system 128.

As used herein, the terms "core element" and "mandrel" are broad terms that include, but are not limited to, an elongated member configured to expand an expandable portion 114. The core element 130 can have a one-piece or multi-piece construction. In some embodiments, the core element has one or more expandable portions (e.g., enlarged and/or tapered portions) which can interact with the expandable portion 114 so as to cause expansion of at least a portion of the expandable portion 114.

As illustrated, the expandable portion 114 may be formed of a plurality of expansion segments 150, with a passageway 156 defined therebetween to engagingly receive the core element 130. The expansion segments 150 may each form a portion of a cylinder or annulus, for example each forming approximately a quarter section of a cylinder. When viewed from either a proximate or distal end, or longitudinally, the arrangement or array of expansion segments 150 may have an approximately circular or oval outer perimeter. The inner perimeter may be polygonal. In operation, the outer perimeter of the expansion segments 150 engage the expandable member 108, or the primary workpiece 112 if no expandable member is to be used. There may be small gaps 152 between adjacent edges of neighboring expansion segments 150 prior to expansion, which gaps 152 increase as the expansion segments 150 are radially expanded outwardly in response to translation of the core element 130 outwardly with respect to the processing tool 102. Alternatively, the adjacent edges may be in contact with one another prior to radial expansion, essentially eliminating any gaps 152.

In the implementation illustrated in Fig. 2A, an inner surface of the expansion segments 150 may be beveled or angled along at least a portion of a length of the expansion segment 150 (e.g., from proximate end to distal end thereof). The bevel or angle may, for example, complement a bevel or angle of the outer surfaces *(i.e.,* expandable portions) of the core element 130. Such may cause the inner surface of the expansion segments 150 to interact with the outer surface(s) of the core element 130 to cause the expansion segments 150 to radially expand outwardly without pivoting of the expansion segments 150. Such may also cause the expansion segments 150 to radially withdraw or retract inwardly without pivoting or the expansion segments 150. Thus, each expansion segment 150 may move perpendicularly with respect to a centerline, longitudinal axis or center or a body or revolution of the expandable portion 114.

The expansion segments 150 may be expandably coupled to one another, for example via one or more bands 154a, 154b (collectively 154). As illustrated, two bands 154a, 154b may couple the expansion segments 150 together at two points along a length of the expandable portion 104. The bands 154a, 154b are radially expandable under the forces expected to be applied to the expansion segments 150. The bands 154 bias the expansion segments 150 into an first, unexpanded configuration. The bands 154 may take the form of steel bands, for example formed of a spring steel. Alternatively, the bands 154 may take the form of elastic bands, formed of one or more elastomers or similar substances having elastomeric properties. The bands 154 are positioned on either side of a center of a length of the array of expansion segments 150, for example proximate either end thereof. This may advantageously allow the outer surfaces of the expansion segments 150 to expandable equally along the entire length of the expandable portion *(i.e.,* move radially without pivoting). This may advantageously eliminate or at least reduce any pivoting that would occur, or example pivoting that would occur when the expansion segments 150 are defined in a unitary structure.

The core element 130 can be moved distally along the path 140 from an initial position (toward the left in Fig. 2A) to an extended position (toward the left in Fig. 2A) to expand the expandable portion 114 from a first configuration to a second configuration. For example, the core element 130 can drive the expandable portion 114 from a radially retracted, withdrawn or collapsed configuration to a radially expanded configuration.

The partially or fully extended core element 130 can also be retracted along the path 140. When the extended core element 130 moves proximally along the path 140 towards its initial position, the expandable portion 114 retracts, withdraw or collapses inwardly. The bands 154 may bias or urge the segments 150 of the expandable portion 114 toward the radially retracted, withdrawn or collapsed configuration. Once the core element 130 is pulled out of the expandable portion 114, the expansion segments 150 may return to their fully retracted, withdrawn or collapsed configuration. In this manner, the expandable portion 114 can be repeatedly moved between the expanded and the retracted, withdrawn or collapsed configurations.

Optionally, a sleeve (not shown) may positioned in the passageway 156, which may form a protective liner between the core element 130 and at least a portion of the expansion segments 150 of the expandable portion 114. Optionally, a lubricant may be provided between the core element 130 and/or the expansion segments 150 of the expandable portion 114. Optionally, a surface of either or both of the core element 130 and/or the expansion segments 150 of the expandable portion 114 may be coated or treated to be lubricious for example treated with a tungsten based coating such as the commercially available under the trademark ULTRALUBE^{®}.

Optionally, the processing tool 102 may include an optional collar 158. The collar 158 may have a central passage sized to receive the expandable portion 114 or the core element portion 130. The collar 158 may be detachably mounted to the processing tool 102 via threads, bayonet mount or other coupler mechanism. The collar 158 may retain the expandable portion 114 to the end of the processing tool 102, allowing selective replacement of same. The collar 158 may retain the core element portion 130 in the processing tool 102, allowing selective replacement of same. The collar may optionally be configured to allow selective adjustment of an amount of travel of the core element 130, for example allowing adjustment or "tuning" of the processing tool for specific tasks.

The processing tool 102 advantageously includes a number of sensors or transducers to sense, measure or detect various operational conditions or parameters.

For example, the processing tool 102 may include a number of pressure sensors S₁, S₂ (only two shown) coupled to sense pressure supplied to the drive system 128. Various types of pressures sensors may be employed. The pressure sensors S₁, S₂ may advantageously be positioned at or proximate the processing tool, to avoid losses associated with the conduits, lines and other structures between the hydraulic reservoir 118 (Fig. 1) and the cylinder 134. This may produce more accurate determination of pressure, which may be particularly advantageous as explained in detail herein with reference to various method of operation. Pressure sensors may, for instance, be used to determine when full forward travel of the core element 130 has occurred and/or when full rearward travel of the core element 130 has occurred. For example, a threshold pressure may be programmed corresponding to the pressure that should be experienced when a hole is radially expanded and/or when the core element 130 hits a stop in returning to the retracted or fully withdrawn position.

Also for example, the processing tool 102 may include a number of position sensors S₃ (only one shown) coupled to sense a position of a moveable element, for example a position of the piston 132. Various types of position sensors may be employed, for example linear variable displacement transducers (LVDTs). The position sensor(s) S₃, S₂ may advantageously be positioned at a face of the piston, for example between rearwardly facing face of the piston 132 and an opposing wall of the cylinder 134. This may produce accurate determinations of position, travel or stroke, which may be particularly advantageous as explained in detail herein with reference to various method of operation.

As another example, the processing tool 102 may include a number of actuation sensors S₄ (only one shown) coupled to sense or detect activation by an end user, for example a pull of trigger 127 or other switch activation. Various types of activation sensors may be employed, for example contact sensors. Accurate determinations of actuation may be particularly advantageous as explained in detail herein with reference to various method of operation.

As yet another example, the processing tool 102 may include a number of accelerometers S₅ (only one shown) to sense or detect orientation and/or acceleration or movement of the processing tool. Various types of accelerometers may be employed, for example 3-axis accelerometers. Accurate determinations of orientation or movement may be particularly advantageous as explained in detail herein with reference to various method of operation.

Fig. 2B shows the processing tool 102 and expansion assembly 104 of Fig. 1, according to one illustrated embodiment. Many of the structures and elements are similar or even identical to those of the implementation illustrated in Fig. 1, and are thus denominated using the same reference numbers as in Fig. 1 or the same reference numbers with a lower case letter "b" appended thereto. Discussion of similar or identical structures and elements is not repeated in the interest of brevity.

The implementation of Fig. 2B adds a number of subsystems as compared to the implementation of Fig. 2A. Various implementations may include one or more of these subsystems, or may omit such as does the implementation of Fig. 2A.

The processing tool 102 may include a control subsystem 200 to read machine-readable symbols 109a, 109c (Fig. 1). The control subsystem 200 may take any of a large variety of forms. Without limiting the alternatives, the control subsystem 200 may include one or more controllers 202, for example one or more microprocessors, DSPs, ASICS, PGAs, PLCs, etc. to programmed or otherwise control operation of the processing tool 102. The controller 202 may be communicatively coupled to one or more nontransitory processor readable media, for instance via one or more buses (not shown). For example, the controller 202 may be coupled to nonvolatile memory which stores instructions and/or data, for instance read only memory (ROM) or Flash memory 204. Additionally, or alternatively, the controller may be coupled to volatile memory which stores instructions and/or data, for instance random access memory (RAM) 206. Alternatively, the processing tool 102 may omit the controller 200 and memory 204, 206, relying on an external system to control operation thereof.

The control subsystem 200 may include a user interface (UI) 208. The UI 208 may, for example include one or more displays, such as an LCD display 210. The UI 208 may include one or more speakers 212, operative to provide audible alerts and possible prompts or instructions to the end user. The UI 208 may include one or more vibrators 214 (e.g., piezoelectric vibration elements) to provide tactile alerts or feedback to the end user. The UI 208 may include the trigger 127, and/or some other switches, keys, or use actuatable buttons or user selectable icons.

The processing tool 102 may include a machine-readable symbol reading subsystem 216 to read machine-readable symbols 109a, 109c (Fig. 1). The machine-readable symbol reading subsystem 216 may take any of a large variety of forms, for example laser based or scanning machine-readable symbol readers or flood illumination or imaging based machine-readable symbol readers. Machine-readable symbol reader scanning units are commercially available in a variety of form factors, including those suitable for inclusion in handheld devices. Without limiting the alternatives, the machine-readable symbol subsystem 216 may include one or more illumination sources 218, or may rely on ambient lighting. Suitable illumination sources 218 may include a laser and scanning mirror (e.g., rotating polygonal mirror). Suitable illumination sources 218 may include one or more LEDs. The machine-readable symbol subsystem 216 may include one or more detectors 220. Suitable detectors 220 may, for example, include linear or two-dimensional arrays of charge coupled devices (CCDs), photodiodes, Vidicons, and/or CMOS imager capture devices. The machine-readable symbol subsystem 216 may include one or more controllers 222, for example one or more microprocessors, DSPs, ASICS, PGAs, PLCs, etc. to programmed or otherwise configured to decode information read from the machine-readable symbols. The controller 222 may be communicatively coupled to one or more nontransitory processor readable media. For example, the controller 222 may be coupled to nonvolatile memory which stores instructions and/or data, for instance read only memory (ROM) or Flash memory 224. Additionally, or alternatively, the controller 222 may be coupled to volatile memory which stores instructions and/or data, for instance random access memory (RAM) 226. Alternatively, the processing tool 102 may omit the controller 222 and memory 224, 226, relying on an external system to decode such information.

In some implementations, the detector(s) 220 may also serve to capture images of the processing, for example images of the primary workpiece 112, hole 110 and/or expandable member 108 during various portions of a processing cycle. One of the processors 202, 222 may control the detector(s) 220 or sample the same, at various defined times, points or events of the processing cycle. The resulting images or image data may be stored to a nontransitory storage medium, for example for later validation of the processing operation. Alternatively or additionally, the resulting images or image data may be computationally analyzed to assess various aspects of the processing and/or materials. Some implementations may include a dedicated imager capture device, in addition to, or in place of the detector(s) 220.

The processing tool 102 may include a wireless transponder reader or interrogation subsystem 230 to read wireless data carriers, for instance radio frequency identification (RFID) transponders 109b, 109c, 109d (Fig. 1). The wireless transponder reader or interrogation subsystem 230 may take any of a large variety of forms, for example operating at various unlicensed or even licensed frequency bands and using any variety of communications protocols (e.g., TDMA, FDMA, CDMA). RFID interrogation units are commercially available in a variety of form factors, including those suitable for inclusion in handheld devices. Without limiting the alternatives, the wireless transponder reader or interrogation subsystem 230 may include one or more antennas 232. The wireless transponder reader or interrogation subsystem 230 may include one or more radios 234 (e.g., transmitter, receiver, transceiver). The wireless transponder reader or interrogation subsystem 230 may include one or more controllers 236, for example one or more microprocessors, DSPs, ASICS, PGAs, PLCs, etc. to programmed or otherwise configured to decode information encoded in the received wireless signals and/or to write information to the wireless transponders and/or perform singulation to isolate wireless transponders. The controller 236 may be communicatively coupled to one or more nontransitory processor readable media. For example, the controller 236 may be coupled to nonvolatile memory which stores instructions and/or data, for instance read only memory (ROM) or Flash memory 238. Additionally, or alternatively, the controller may be coupled to volatile memory which stores instructions and/or data, for instance random access memory (RAM) 240. Alternatively, the processing tool 102 may omit the controller 236 and memory 238, 240, relying on an external system to decode such information.

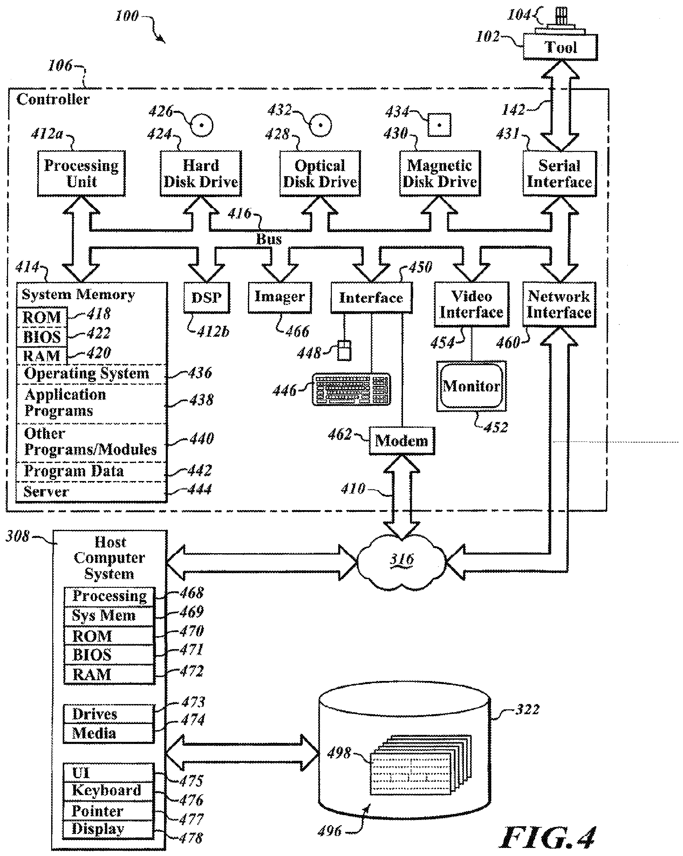

The processing tool 102 may include a wireless transponder reader or spatial location subsystem 242 to determine a spatial location of the processing tool 102 or facilitate determination that spatial location. The spatial location subsystem 242 may take any of a large variety of forms, for example operating employing time-of-flight determination, triangulation and/or global positioning system (GPS) location determination. Various spatial location determination units (e.g., GPS) are commercially available in a variety of form factors, including those suitable for inclusion in handheld devices. Without limiting the alternatives, the spatial location subsystem 242 may include one or more antennas 244. The spatial location subsystem 242 may include one or more radios 246 (e.g., transmitter, receiver, transceiver). The spatial location subsystem 242 may include one or more controllers (not shown), for example one or more microprocessors, DSPs, ASICS, PGAs, PLCs, GPUs, etc. to programmed or otherwise configured to decode information encoded in the received wireless signals and/or to write information to the wireless transponders and/or perform singulation to isolate wireless transponders. The controller may be communicatively coupled to one or more nontransitory processor readable media (not shown), for example nonvolatile or volatile memory. Alternatively, the processing tool 102 may rely on an external system to determine spatial location, for example using triangulation based on signals received at various external antennas (Fig. 4) from the radio 246.

The processing tool 102 may include one or more communications ports 248. The communications port(s) 248 may provide communications with devices external to the processing tool 102. The communications ports 248 may include wired as well as wireless ports. For example, the communications ports 248 may include Ethernet ports, Universal Serial Bus (USB) ports, Firewire ports, Thunderbolt ports, etc., and/or ports compliant with various IEEE 802.11 protocols.

While Figures 2A and 2B illustrate a particular expansion assembly, other structures may be employed. For example, the structures described in U.S. patent 8,069,699 may be used.

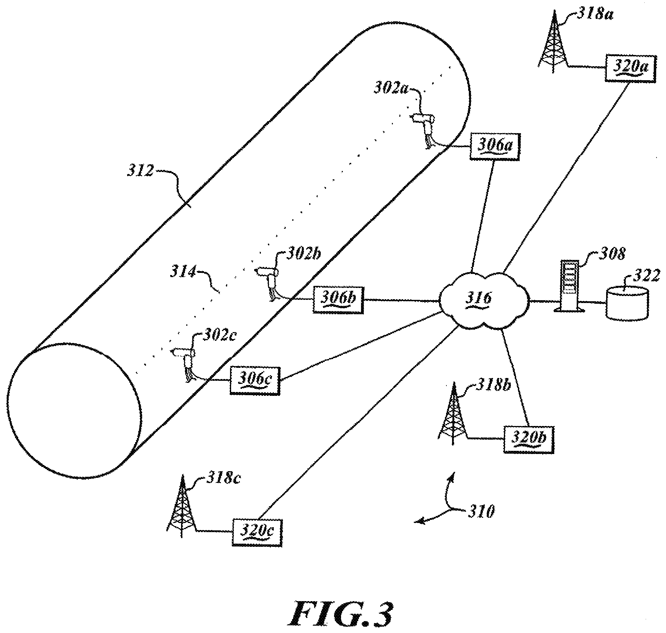

Fig. 3 shows a processing system 300 including a plurality of processing tools 302a-302c (only three shown, collectively 302), processor-based controllers 306a-306c (only three shown, collectively 306), one or more host computer systems 308 (only one shown), and a spatial location system 310 positioned relative to a primary workpiece 312, according to one illustrated embodiment.

The primary workpiece 312 may take a variety of forms, and may for example be large enough that two or more end users will work on the workpiece concurrently or simultaneously. An example of such is a portion of an aircraft, for instance a fuselage or wing. The primary workpiece 312 may include a plurality of holes 314 (only one called out in Fig. 3) into which expandable members 108 Fig. 1) may be installed, for instance via radial expansion that achieves cold working stress relief in the workpiece 312 proximate each hole 314. Alternatively, the holes 314 may be cold worked without the installation of an expandable member.

The processing tools 102 and processor-based controller 106 may take the form of those described in reference to Figures 1, 2A and 2B. These may be communicatively coupled to the host computer system(s) 308, for example via a wired and/or wireless network 316, for example a local area network or wide area network. Any conventional networking infrastructure or protocol may be employed.

The spatial location system 310 may determine or facilitate determination of specific locations of the processing tools 302, for example during use. Such may be used to determine a spatial location of the processing tool 302 each time the processing tool 302 is operated, for example each time a trigger is pulled. Such may be particularly advantageous where the processing tools 302 are handheld, thus can be used in a relative uncontrolled manner as compared for example to CNC machining. This information may combined with other information to uniquely characterize the installation in, or other processing of, each hole 314 in the workpiece 312. The spatial location system 310 may include a number of antennas 318a-318c (only three shown, collectively 318) and radios 320a-320c (only three shown, collectively 320). The number and positioning of the antennas 318 may be sufficient to allow triangulation. In some implementations a single radio 320 may be shared between two or more antennas 318. The host computer system 308 may be configured to use information from the radios 320 to determine a spatial location of each of the processing tools 302, for example using triangulation or time of flight techniques. Alternatively, or additionally, the processing tools 302 or processor-based controller 306 may determine spatial location based on receipt of signals from the antennas 318.

The host computer system 308 may take the form of a server computer system and may include one or more nontransitory storage media 322. The nontransitory storage media 322 may take any of a large variety of forms, for instance hard disk, optical media, tape, etc. The host computer system 308 may track and/or store information to the nontransitory storage media 322. For example, host computer system 308 stores information which characterizes each use of a processing tool 302. The information may be combined with location information, allowing various operational conditions *(e.g.,* force, pressure, travel, yield, deformation, angles, nominal geometry) to be recorded for each hole 314. Such may provide documentary evidence of each installation, cold expansion, or other such processing operation instance *(e.g.,* cold worked radial expansion).

Fig. 4 shows a portion of a material-processing system 100 comprising a processor-based controller 106 communicatively coupled to a processing tool 102, and a host computer system 308 communicatively coupled to the processor-based control system 106, according to one illustrated embodiment. Fig. 4 provides a more detailed representation of some of the elements of Figures 1 and 3.

The processor-based controller 106 will at times be referred to in the singular herein, but this is not intended to limit the embodiments to a single device or system since in typical embodiments, there may be more than one processor-based controller 106 involved. While illustrated in Fig. 2A as separate from or external with respect to the processing tool 102, the processor-based controller 106 may be part of the processing tool 102, for example as illustrated in Fig. 2B. Unless described otherwise, the construction and operation of the various blocks shown in Fig. 4 are of conventional design. As a result, such blocks need not be described in further detail herein, as they will be understood by those skilled in the relevant art.

The processor-based controller 106 may include one or more processing units 412a, 412b (collectively 412), a system memory 414 and a system bus 416 that couples various system components including the system memory 414 to the processing units 412. The processing units 412 may be any logic processing unit, such as one or more central processing units (CPUs) 412a, DSPs 412b, application-specific integrated circuits (ASICs), field programmable gate arrays (FPGAs), graphics processor units (GPUs), etc. The system bus 416 can employ any known bus structures or architectures, including a memory bus with memory controller, a peripheral bus, and a local bus. The system memory 414 includes read-only memory ("ROM") 418 and random access memory ("RAM") 420. A basic input/output system ("BIOS") 422, which can form part of the ROM 418, contains basic routines that help transfer information between elements within the processor-based controller 106, such as during start-up.

The processor-based controller 106 may include a hard disk drive or solid-state drive (SSD) 424 for reading from and writing to a magnetic disk 426 or solid-state non-volatile memory such as flash EEPROM media (not shown), an optical disk drive 428 for reading from and writing to removable optical disks 432, and/or a magnetic disk drive 430 for reading from and writing to magnetic disks 434. The optical disk 432 can be a CD/DVD-ROM, while the magnetic disk 434 can be a magnetic floppy disk or diskette. The hard disk drive 424, optical disk drive 428 and magnetic disk drive 430 may communicate with the processing unit 412 via the system bus 416. The hard disk drive 424, optical disk drive 428 and magnetic disk drive 430 may include interfaces or controllers (not shown) coupled between such drives and the system bus 416, as is known by those skilled in the relevant art. The drives 424, 428 and 430, and their associated computer-readable storage media 426, 432, 434, may provide nonvolatile and non-transitory storage of computer readable instructions, data structures, program engines and other data for the processor-based controller 106. Although the depicted processor-based controller 106 is illustrated employing a hard disk 424, optical disk 428 and magnetic disk 430, those skilled in the relevant art will appreciate that other types of computer-readable storage media that can store data accessible by a computer may be employed, such as magnetic cassettes, flash memory, digital video disks ("DVD"), Bernoulli cartridges, RAMs, ROMs, smart cards, etc. The hard disk 426 may, for example, store instructions and/or data to collect information or data from the processing tool 102 and/or control the processing tool 102. The instructions may cause the processor-based controller 106 to control the processing tool 102 according to a defined algorithm, which may, or may not, take into account information or data sensed by sensors (e.g., sensors S₁-S₅ of Figures 2A and 2B) of the processing tool 102.

Such may form a real-time or dynamic feedback system, adjusting operation of the processing tool 102 based on sensed operational conditions, including conditions that are related to the workpiece or a component (e.g., expandable member) to be installed in a hole in the workpiece. Such may also detect abnormalities in operation (e.g., sequence out of order, unexpected condition, angle or orientation of processing tool, incorrect material, excessive cycles or wear, over temperature, over or under pressure conditions). Such may automatically correct for certain abnormalities, provide an alert or even prompt a user with a suggested corrective action. For example, on occurrence of certain abnormal conditions, the instructions may cause the processing tool to retract the core element 130 (Fig. 2A, 2B) before achieving a defined or desired radial expansion, allowing realignment of the processing tool 102. Additional details regarding such operation, as well as other operations are discussed herein with respect to the various methods of operation.

Program engines can be stored in the system memory 414, such as an operating system 436, one or more application programs 438, other programs or engines 440 and program data 442.

Application programs 438 may include instructions that cause the processor(s) 412 to automatically collect, store and/or update information regarding a particular operation (e.g., installation, cold work radial expansion). Such may, for example be on a hole by hole basis, workpiece-by-workpiece basis, and/or user-by-user basis. Application programs 438 may include instructions that cause the processor(s) 412 to analyze data or information representative of operating conditions, and/or control operation of the processing tool 102 based on the analysis. Analysis of data may include, for example one or more of determining initial contact with a material, determining initial hole size, determining yield point of material, determining an amount of radial expansion past a yield point of material, determining an end point, determining whether the material has characteristics consistent with expected material, determining orientation of processing tool at various times or steps of an operation cycle, among other operational characteristics. Analysis, alerts, corrective actions, suggestive prompts, and related data or information may be stored for future reference, for example stored via nontransitory storage media 322 (Fig. 3). Collected data representing the operation of the processing tool 102, the characteristics of a workpiece 112 (Fig. 1), and/or characteristics of an expandable member 108 (Fig. 1) fixed or fixable in a hole 110 in the primary workpiece 112, may be stored to the nontransitory storage media 426, 432, 434, for example in one or more data structures, for instance in data structures of a database (e.g., relational database).

Application programs 438 may also include instructions to determine a spatial location of the processing tool 102 based on information received from the spatial location system (Fig. 3) and/or processing tool 102 or processor-based controller 106. For example, the instructions may include a triangulation algorithm or other algorithm for accessing location based on signals (e.g., signal strength, signal timing) received at a number of spaced apart antennas or received from a number of spaced apart antennas. Any form of location determination may be employed. Program engines may also include instructions to record abnormalities and/or send or transmit alerts or messages on occurrence of certain events, such as abnormalities in operation or divergence from expected materials or characteristics (e.g., hole size, yield point). Alerts may be visual, aural, and may include electronic communications including text messages, emails, automated voicemail or phone messages.

Application programs 438 may also include instructions to monitor usage of the processing tool and/or a consumable component (e.g., expansion assembly 104, core element 130, expansion segments 150 or expansion segment bundle 114). Such may, for example, monitor a total number of uses or cycles (e.g., complete operating cycles) to which each component has been subjected. Such may additionally or alternatively monitor a level of wear of the components. Such may additionally or alternatively monitor a time in service of components. The application program 438 may provide alerts once a threshold condition (e.g. maximum permitted cycles, maximum wear or minimum surface). The application program 438 may provide alerts in anticipation of reaching a threshold, for example at 80% and/or 90% of threshold, allowing ordering of replacement part(s), or even automatically generating an electronic order for replacement part(s). Alerts may be provided to a user of the processing tool, as well as to remotely located individuals such as managers or procurement personnel.

Application programs 438 may also include instructions to limit usage of the processing tool 102 and/or a consumable component (e.g., expansion assembly 104, core element 130, expansion segments 150 or expansion segment bundle 114). Such may, for example, prevent continued usage of a processing tool once certain thresholds of processing tool usage have been reached. Such may, for example, prevent continued usage of a consumable component (e.g., expansion assembly 104, core element 130, expansion segments 150 or expansion segment bundle 114) once certain thresholds of consumable component usage have been reached. For example, operation of a processing tool 102 may be disabled while a particular consumable component is coupled thereto. Such may be implemented, for example by use of identifiers physically or at least proximally associated with the consumable components. For example, identifiers may be read from a machine-readable symbol 109a (Fig. 1) or wireless transponders 109b (Fig. 1) associated with the consumable component. Such allow tracking of usage of the consumable component, even when such usage occurs with two or even more processing tools 102. Usage, or other lifetime limiting information may be stored in a database at the processor-based controller 106 or host computer system 308. Additionally, or alternatively, usage, or other lifetime limiting information may be stored in a nontransitory storage medium physically associated with the processing tool 102 and/or consumable component. For instance, the information may be stored to an RFID tag 109d (Figures 2A, 2B) carried by the consumable component. The information may be updated from time-to-time to reflect usage, for example being written to after each complete cycle of processing a hole in a workpiece. Pairing the information with the consumable component prevents continued usage of the consumable component even when switched to a different processing tool 102. The processing tool 102 or processor-based controller 106 may be programmed such that they are rendered inoperative unless physically paired with a consumable component with a valid RFID tag 109b (Fig. 1) and with a flag, count or other piece of data stored therein which indicates that usage limits for that particular consumable component have not exceeded.

Other program engines 440 may include instructions for handling security such as password or other access protection and communications encryption. The system memory 414 may also include communications programs, for example, a server 444 for permitting the processor-based controller 106 to provide services and exchange data with other computer systems or devices via the Internet, corporate intranets, extranets, or other networks (e.g., LANs, WANs) as described below, as well as other server applications on server computing systems such as those discussed further herein. The server 444 in the depicted embodiment may be markup language based, such as Hypertext Markup Language (HTML), Extensible Markup Language (XML) or Wireless Markup Language (WML), and operates with markup languages that use syntactically delimited characters added to the data of a document to represent the structure of the document. A number of servers are commercially available such as those from Microsoft, Oracle, IBM and Apple.

While shown in Fig. 4 as being stored in the system memory 414, the operating system 436, application programs 438, other programs/engines 440, program data 442 and server 444 can be stored on the SSD/hard drive 424, the optical disk 432 of the optical disk drive 428 and/or the magnetic disk 434 of the magnetic disk drive 430.

An operator can enter commands and information into the processor-based controller 106 through input devices such as a touch screen or keyboard 446 and/or a pointing device such as a mouse 448, and/or via a graphical user interface. Other input devices can include a microphone, joystick, game pad, tablet, scanner, etc. These and other input devices are connected to one or more of the processing units 412 through an interface 450 such as a serial port interface that couples to the system bus 416, although other interfaces such as a parallel port, a game port or a wireless interface or a universal serial bus ("USB") can be used. A monitor 452 or other display device is coupled to the system bus 416 via a video interface 454, such as a video adapter. The processor-based controller 106 can include other output devices, such as speakers, printers, etc.

The processor-based controller 106 may be communicatively coupled to the processor tool 102, for example via a dedicated communications channel such as a set or wires or wire bundle 142, employing serial or parallel communications. Alternatively, the processor-based controller 106 may be communicatively coupled to the processor tool 102 via a shared, network communications channel. The processor-based controller 106 can operate in a networked environment using logical connections to one or more remote computers and/or devices as described above with reference to Fig. 3. For example, the processor-based controller 106 can operate in a networked environment 316 (Fig. 3) using logical connections to one or more host computer systems 308. Communications may be via a wired and/or wireless network architecture, for instance, wired and wireless enterprise-wide computer networks, intranets, extranets, and the Internet. Other embodiments may include other types of communication networks 316 including telecommunications networks, cellular networks, paging networks, and other mobile networks.

The host computer system 308 may take the form of a conventional mainframe computer, mini-computer, workstation computer, personal computer (desktop or laptop), or handheld computer. The host computer system 308 may include a processing unit 468, a system memory 469 and a system bus (not shown) that couples various system components including the system memory 469 to the processing unit 468. The host computer system 308 will at times be referred to in the singular herein, but this is not intended to limit the embodiments to a single host computer system 308 since in typical embodiments, there may be more than one host computer system 308 or other device involved. Non-limiting examples of commercially available computer systems include, but are not limited to, an 80x86, Pentium, or i7 series microprocessor from Intel Corporation, U.S.A., a PowerPC microprocessor from IBM, a Sparc microprocessor from Sun Microsystems, Inc., a PA-RISC series microprocessor from Hewlett-Packard Company, or a 68xxx series microprocessor from Motorola Corporation.

The processing unit 468 may be any logic processing unit, such as one or more CPUs, DSPs, ASICs, FPGAs, etc. Unless described otherwise, the construction and operation of the various blocks shown in Fig. 4 are of conventional design. As a result, such blocks need not be described in further detail herein, as they will be understood by those skilled in the relevant art.

The system bus can employ any known bus structures or architectures, including a memory bus with memory controller, a peripheral bus, and a local bus. The system memory 469 includes read-only memory ("ROM") 470 and random access memory ("RAM") 472. A basic input/output system ("BIOS") 471, which can form part of the ROM 470, contains basic routines that help transfer information between elements within the host computer system 308, such as during start-up.

The host computer system 308 may also include one or more media drives 473 (e.g., a hard disk drive, magnetic disk drive, and/or optical disk drive) for reading from and writing to computer-readable storage media 474 (e.g., hard disk, optical disks, and/or magnetic disks). The computer-readable storage media 474 may, for example, take the form of removable media. For example, hard disks may take the form of a Winchester drives, optical disks can take the form of CD-ROMs, while magnetic disks can take the form of magnetic floppy disks or diskettes. The media drive(s) 473 communicate with the processing unit 468 via one or more system buses. The media drives 473 may include interfaces or controllers (not shown) coupled between such drives and the system bus, as is known by those skilled in the relevant art. The media drives 473, and their associated computer-readable storage media 474, provide nonvolatile storage of computer readable instructions, data structures, program engines and other data. Although described as employing computer-readable storage media 474 such as hard disks, optical disks and magnetic disks, those skilled in the relevant art will appreciate that host computer system 308 may employ other types of computer-readable storage media that can store data accessible by a computer, such as magnetic cassettes, flash memory cards, digital video disks ("DVD"), Bernoulli cartridges, RAMs, ROMs, smart cards, etc. Data or information, for example, data collected from operation of processing tool(s) 102 related to processing tool operational conditions and analysis of same, can be stored in the computer-readable storage media 474. The data related to operational conditions may include data that is indicative of properties of primary workpieces 112 (Fig. 1) or elements (e.g., expandable members 108) fixable or fixed in holes 110 of the primary workpieces, to the extent such is discernible directly by the sensors S₁-S₅ (Figures 2A, 2B) or indirectly by analysis of conditions or parameters sensed by the sensors S₁-S₅ and/or other sensors (e.g., temperature sensors for instance thermocouples). Additionally, or alternatively, data or information, for example, data used for controlling operation of processing tool(s) 102, can be stored in the computer-readable storage media 474.

Program engines, such as an operating system, one or more application programs, other programs or engines and program data, can be stored in the system memory 469. Program engines may include instructions to store and/or retrieve information regarding operation of the processing tool(s) 102, and particularly information related to each processing operation perform by the processing tool 102. For example, a program engine may store and/or retrieve collected data representing the operation of the processing tool 102, the characteristics of a primary workpiece 112 (Fig. 1), and/or characteristics of an expandable member 108 (Fig. 1) fixed or fixable in a hole 110 in the primary workpiece 112, to the nontransitory storage media 322. Such may, for example, be stored in and/or retrieved from one or more data structures 498, for example data structures of a relational database 496.

Program engines may include instructions for handling security such as password or other access protection and communications encryption. The system memory 469 may also include communications programs, for example, a Web client or browser that permits the host computer system 308 to access and exchange data with sources such as Web sites of the Internet, corporate intranets, extranets, or other networks as described below, as well as other server applications on server computing systems such as those discussed further below. The browser may, for example, be markup language based, such as Hypertext Markup Language (HTML), Extensible Markup Language (XML) or Wireless Markup Language (WML), and may operate with markup languages that use syntactically delimited characters added to the data of a document to represent the structure of the document.

While described as being stored in the system memory 469, the operating system, application programs, other programs/engines, program data and/or browser can be stored on the computer-readable storage media 474 of the media drive(s) 473. An operator can enter commands and information into the sending client computer system 114a via a user interface 475 through input devices such as a touch screen or keyboard 476 and/or a pointing device 477 such as a mouse. Other input devices can include a microphone, joystick, game pad, tablet, scanner, etc. These and other input devices are connected to the processing unit 469 through an interface such as a serial port interface that couples to the system bus, although other interfaces such as a parallel port, a game port or a wireless interface or a universal serial bus ("USB") can be used. A display or monitor 478 may be coupled to the system bus via a video interface, such as a video adapter. The host computer system 308 can include other output devices, such as speakers, printers, etc.

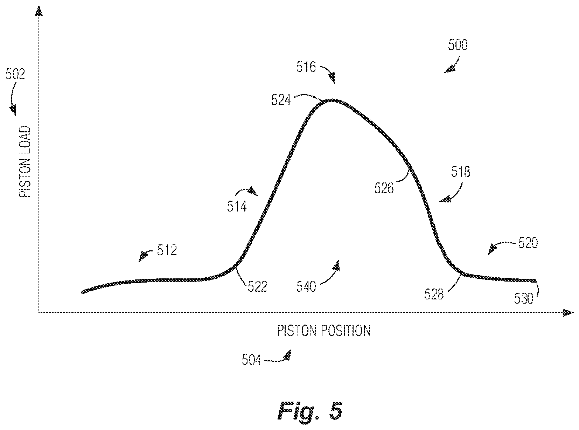

Fig. 5 is a diagram illustrating a work profile response relationship for an example process. As depicted, response relationship 500 represents a force curve or pressure curve measured during the processing of a primary workpiece 112 (Fig. 1), according to an illustrated embodiment. The processing may take a variety of forms, for example radial expansion of a hole 110 (Fig. 1) in the primary workpiece 112 to achieve cold working stress relief in the material surrounding the hole 110. Such may be performed directly on a hole 110, or may additionally secure an expandable member 108 (e.g., bushing, flanged bushing, rivetless nut plate, grommet) in the hole 110 via a high interference fit.

The response relationship 500 may be a function of two or more variables. As illustrated, the response relationship 500 is a function of a first variable 502, for instance an applied force, a reaction force to the applied force, or a pressure, and a second variable, for instance a position, or distance or amount of travel. For example, where a processing tool employs a piston and cylinder driven by hydraulics, the first variable 502 may take the form of a measure of load or pressure exerted by the piston. Such may advantageously be measured proximate the piston (e.g., at inlet valve to cylinder) via any variety of pressure sensors or transducers. Alternatively, a force sensor may detect an amount of force applied by the piston or some other drive element *(e.g.,* core element, segments of expansion assembly). The second variable 504 may, for example be a position of the piston at any given time, or an amount or distance the piston has traveled. In other examples, the second variable may be a position of some other drive element (e.g., core element, segments of expansion assembly). Such may be measured via a variety of position sensors, for instance a LVDT, or an encoder for instance an optical encoder or magnetic encoder such as a Reed switch. Other variables may be employed, for example temperature, strain, and/or stress.

Sensors or other transducers may be sampled from time-to-time, for example periodically to determine values for the variables. For example, sampling rates of between 1KHz and 10KHz may provide suitable results. Higher sampling rates will typically produce suitable results but may not be justified in light of the computational effort. Lower sampling rates may be possible, however may not prove as responsive.

For convenience of illustration, the response relationship may be plotted or graphed on a plot or graph, for example as illustrated in Fig. 5. The plot or graph may, for instance have pressure, force or reaction force along a vertical axis and position or distance traveled along a horizontal axis. While illustrated as a plot or graph, the response relationship may be represented in other forms, particularly other forms suitable for computational analysis by processors (e.g., microprocessors, DSPs, AISCs, PGAs, PLUs, GPUs) using analytical or numerical analysis techniques. For instance, the response relationship may be represented as time-series data, as a set of pairs of values or vectors, or as parameters or equations (e.g., polynomial equations, B-spline equations, or nonrational B-spline equations).

Starting from the left of Fig. 5, the response relationship 500 will may include a first portion 512, a second portion 514, a third portion 516, a fourth portion 518, and a fifth portion 520. A first inflection point 522 may occur between the first and the second portions 512, 514, a second inflection point 524 between the second and third portions 514, 516, a third inflection point 526 between the third and fourth portions 516, 518, and a fourth inflection point 528 between the fourth and fifth portions 518, 520. The response relationship 500 terminates at a limit of travel, stroke or termination point 530.

The first portion 512 is a period in which the expansion assembly expands but has yet to contact an inner surface of a hole or expandable element to be fixed or secured in the hole. Such is characterized by a changing position without much, if any, change in pressure, force or reaction force. Where plotted or graphed on a plot or graph such as that in Fig. 5, the first portion 512 may appear as a generally flat horizontal portion.

The first point of inflection 522 corresponds to a period in which the expansion assembly engages the inner surface of the hole or expandable element to be fixed or secured in the hole. Such is characterized by a rapid change in pressure, force or reaction force versus a small change in position.

The second portion 514 is a period in which the expansion assembly gradually or steadily expands the hole or expandable element to be fixed or secured in the hole, starting at or proximate the first inflection point 522. The radial expansion induces compressive stresses in the primary workpiece, mostly in the elastic range of the material. Such is characterized by a relatively linear relationship between change in position and change in pressure, force or reaction force. Where plotted or graphed on a plot or graph such as that in Fig. 5, the second portion 514 may appear as a smooth rise, which may be a relatively linear rise having a relatively fixed slope.

The second point of inflection 524 occurs at the peak load, corresponding to the point of material yield or change in compliance of the material. This is the point at which the contact pressure applied via the expansion assembly had exceeded the yield strength of the material of the structure (e.g., primary workpiece), hence the change in compliance of the material occurs.

The third portion 516 is a period in which the expansion assembly continues to gradually and/or steadily expand the hole and/or expandable element to be fixed or secured in the hole. The radial expansion induces compressive stresses in the workpiece, mostly in the plastic range, permanently expanding the hole and beneficially inducing residual stresses. Such is characterized by a relatively linear relationship between change in position and change in pressure, force or reaction force.

The fourth inflection point 528 is the point at which the expansion assembly disengages with the workpiece.

The area 540 under the response relationship 500 represents the amount of work done as part of the process in this example.

Variations in process parameters, such as workpiece material composition, workpiece thickness, and hole size, can affect the shape of the response relationship 500. For example, the hole size tends to affect the position of the first inflection point 522 (and, consequently, the distance between the first inflection point 522 and the fourth inflection point 528), as well as the peak load corresponding to the second inflection point 524, and the slope of second portion 514 of the response relationship 500. Changes om material thickness of the workpiece tend to primarily affect the position of the first inflection point 522 and the distance between the first inflection point 522 and the fourth inflection point 528, with the peak load and slopes remaining generally consistent. Solid bulk-material workpieces and layered workpieces may cause different shapes of the respective work profiles, such as the latter imparting a degree of concave curvature of the third portion 516 of the response relationship 500.

Other features of the work profile of the response relationship 500 may be indicative of other characteristics of the processing arrangement. For instance, combinations of features may indicate the amount of applied expansion of the hole, the thickness of a layered stack of workpiece material, the contact pressure at the hole, the amount of hole expansion that is retained at the conclusion of the processing, the extent of material yield, or other characteristics of the workpiece geometry.

Importantly, the response relationship 500 provides information which may be advantageously used to characterize the processing operation and/or materials (e.g., primary workpiece, expandable member to be secured in primary workpiece). The response relationship 500 or information discerned from the response relationship 500 may be stored, allowing later inspection or validation of the processing operation, for example on a hole-by-hole basis, or allowing later inspection or validation of materials, for example on a workpiece-by-work piece basis. Such may also allow assessment on a user or operator, storing information searchable on a user-by-user basis. Such allows identification of operations or acts requiring further training of individuals or groups of users, or identification of individuals who are unsuited for performing the tasks required.

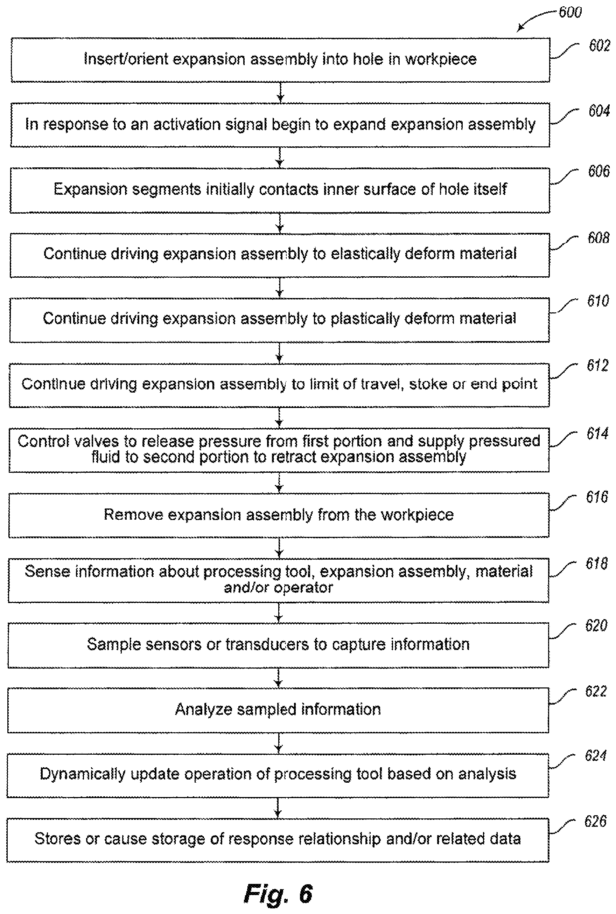

Fig. 6 shows a high level method 600 of operating a processing system, according to one illustrated embodiment. At 602, an expansion assembly detachably physically coupled to a processing tool is inserted into a hole in a workpiece. Such may be inserted with an expansion member which is to be secured at least partially in the hole in the workpiece by radial expansion cold working. Such may include orienting the expansion assembly and/or processing tool with respect to the hole, the workpiece and/or global coordinates (e.g., gravitational vector). At 604, in response to an activation signal (e.g., trigger pull, signal processor-based controller), the processing tool beings to expand the expansion assembly. For example, the processing tool or processor-based controller opens one or more valves to supply pressurized fluid to a first portion of a cylinder to drive a piston. The processing tool or processor-based controller may also open one or more valves to release pressure from to a second portion of the cylinder to allow the piston to move into the second portion of the cylinder. The piston in turn may drive a core element or mandrel which physically engages expansion surfaces of a plurality of expansion segments of an expansion assembly, driving the expansion segments radially outward. Such expansion is represented as the first portion of the response relationship 500. As noted above, such may advantageously be performed without pivoting, but rather the segments may move radially perpendicularly outward from a central or longitudinal axis of the expansion assembly.

At 606, the expansion segments may make initial contact with an expansion member to be secured in a hole of a workpiece via an interference fit, or with an inner surface of the hole itself. Such initial contact is typically a function of initial hole size of the hole and is represented as the first inflection point of the response relationship 500.

At 608, the piston continues to drive the expansion assembly to radially expand the expansion segments, elastically deforming the material *(e.g.,* portion of workpiece surround hole). Such deformation is typically smooth or linear, with a slope that is characteristic of the particular material. Such is represented as the second portion of the response relationship 500.

At 610, the piston continues to drive the expansion assembly to radially expand the expansion segments, plastically deforming the material (e.g., portion of workpiece surround hole). Such deformation is typically smooth or linear, with a slope that is also characteristic of the particular material. The inflection point between the portions is likewise characteristic of the particular material. Such is represented as the third portion of the response relationship 500.

At 612, the piston continues to drive the expansion assembly, however the radial expansion is limited by the resistance of the material to further deformation. Such limit is also characteristic of the particular material. Such is represented as the fourth portion of the response relationship 500, terminating at the limit of travel or stoke end point.

At 614, the processing tool or processor-based controller, opens a valve to release pressure from the first portion of the cylinder. The processing tool or processor-based controller also opens one or more valves to supply pressure fluid to the second portion of the cylinder, to drive the piston to the first portion. Such drives the drive member in the opposite direction then at 602, causing the expansion segments of the expansion assembly to retract.

At 616, the expansion assembly is removed from the workpiece.

At 618, one or more sensors or transducers sense information about the processing tool, the expansion assembly, the material and/or operator. Such may be performed substantially continuously, during performance of 604-614. Alternatively, such may be performed at or during defined portions of the method 600.

At 620, at least one processor samples the one or more sensors or transducers, to capture information about the processing tool, the expansion assembly, the material and/or operator. Such may be performed substantially continuously, during performance of 604-614. Alternatively, such may be performed at or during defined portions of the method 600.

At 622, at least one processor analyzes the information sampled from the one or more sensors or transducers. Analysis may take a variety of forms. For example, analysis may compare certain values (e.g., slopes, ratio of slopes, inflection points, points of initial contact, end points) to expected values. Such may be performed substantially continuously, during performance of 604-614. Alternatively, such may be performed at or during defined portions of the method 600. As described in greater detail below, the analysis at operation 622 utilizes one or more machine-learning techniques, such as a trained deep neural network, to classify the measured response relationship 500 as within acceptable limits, or as falling outside of the acceptable limits.

At 624, at least one processor dynamically updates operation of the processing tool based on the analysis. For example, the at least one processor may determine a new end point based on the analysis, for example compensating for a variation in material property (e.g., thickness, initial hole size, yield strength). **It** has been noted that some pieces of material may have very large variations in certain material characteristics, form piece to piece, even when from single manufacturer, and from the same batch or shipment. Also for example, the at least one processor may determine to disengage from the material, retracting the expansion segments of the expansion assembly, to eventually reengage the material or alternatively to completely stop, abandon or abort the process on the particular workpiece. As a further example, the at least one processor may determine to produce an alert, and cause the production of such alert. As yet a further example, the at least one processor may determine to adjust pressure or applied force to vary a speed of the expansion as compared to a previously defined speed. Such may be performed substantially continuously, during performance of 604-614. Alternatively, such may be performed at or during defined portions of the method 600.

At 626, the at least one processor stores or causes the storage of the response relationship, data defining the response relationship or information discerned therefrom. For example, the at least one processor may store information in one or more nontransitory storage media collocated with the processor, or may cause the storage of such in one or more nontransitory storage media coupled to store information from a plurality of processing tools. Such may be performed substantially continuously, during performance of 604-614. Alternatively, such may be performed at or during defined portions of the method 600.

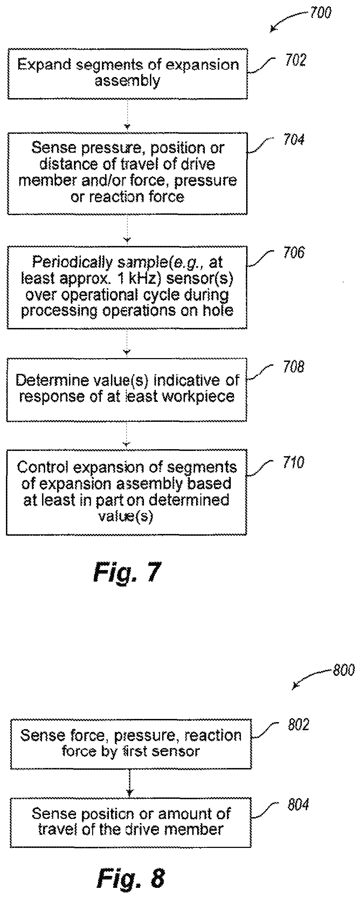

Fig. 7 shows a method 700 of dynamically operating a processing tool of a processing system, accordingly to one illustrated embodiment. At 702, the processing tool or processor-based controller expands a plurality of expansion segments of an expansion assembly.

At 704, one or more sensor sense at least one of pressure, position of a drive member of the processing tool or consumable expansion assembly, a distance of travel of the drive member, and/or a reaction force resulting from an applied force applied directly or indirectly by the expanding of the expansion segments to an interior surface of a hole in a workpiece. Such may, for example, be applied directly to the interior surface of the hole, to cold work the portion of the workpiece surrounding the hole, for instance to induce residual stress to reduce fatigue cracking. Such may, for example, be applied directly to a secondary workpiece *(e.g.,* bushing, flanged bushing, rivetless nut plate, grommet) to produce an interference fit between a portion of the secondary workpiece and an interior surface of a hole in a primary workpiece. Such may secure the secondary workpiece to the primary workpiece, and may also cold work the portion of the primary workpiece surrounding the hole, for instance to induce residual stress to reduce fatigue cracking.

At, 706, at least one processor periodically samples the sensor(s) over an operational cycle during which the processing tool performs a plurality of operations on the first hole. The processor samples the sensor(s) at a suitable frequency to allow dynamic operation. Frequencies from approximately 1KHz to approximately 10KHz have been found to be suitable sampling frequencies, balancing responsiveness with computational overhead.

At 708, the at least one processor determines at least one value indicative of a response of at least a portion of at least the primary workpiece to the applied force applied directly or indirectly by expanding of the expansion segments. A variety of suitable values are described herein, for example response relationship, slopes, ratio of slopes, position or size of initial contact, point or size at termination, end point or travel limit, various points of inflection, to name a few.

At 710, the at least one processor controlling expands the expansion segments of the expansion assembly based at least in part on the determined value(s). The processor may use any one or more of the values to dynamically adjust expansion. For example, the processor(s) may adjust or accommodation variations in initial size of the hole, variations in thickness of the primary workpiece or variations in other physical characteristics of the primary workpiece such as point of yield or yield strength. The processor(s) may control a size of expansion, rate of expansion, or even cause retraction of the expansion segments, and/or abandonment of a processing operation, for instance in response to an abnormality or out-of-tolerance condition.

Fig. 8 shows a method 800 of dynamically operating a processing tool of a processing system to sense parameters or conditions, accordingly to one illustrated embodiment. The method 800 may be useful in executing the method 700, for example in performing sensing 704. At 802, at least a first number of sensors sense at least one of: a force or pressure applied to, or by, a drive member, or a reaction force resulting from the applied force. The reaction force may result from force or pressure applied indirectly to the interior surface of the hole, via the drive member, the expansion segments, and, optionally an expansion member being installed in the hole. Sensors may, for example, include pressure sensors and/or force sensors. In some example implementations, pressure sensors may be located as close to the drive member as possible, to minimize the effect of line loses, producing a more accurate reading or measurement.

At 804, at least a second number of sensors sense information indicative of a position of the drive member or an amount of travel of the drive member between two positions. Sensors may include any type of position sensor, for instance LVDTs or position encoders.

### Machine Learning-Based Analytical System for Cold Working Performance Assessment

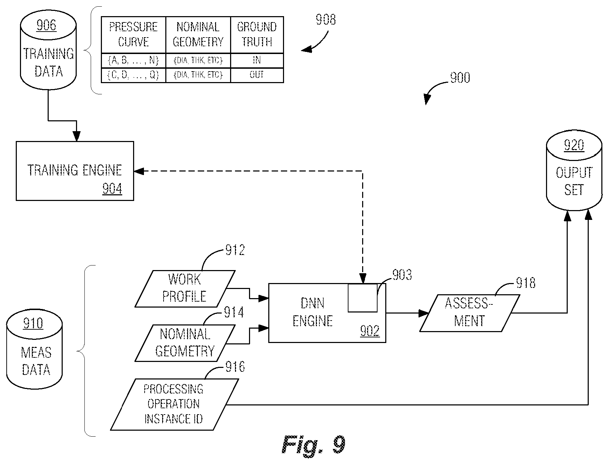

Fig. 9 is a system block diagram illustrating a machine-learning-based assessment system 900 operative to determine whether individual material- processing operations, such as radial expansion cold working (e.g., Cx) operational instances, were completed within the applicable specification, according to an example embodiment. As depicted, system 900 includes a set of engines as will be described below.

The term "engine" as used herein means a tangible device, circuit, component, or arrangement thereof, implemented using hardware, such as by an application specific integrated circuit (ASIC) or field-programmable gate array (FPGA), for example, or as a combination of hardware and software, such as by a processor-based computing platform and a set of program instructions that transform the computing platform into a special-purpose device to implement the particular functionality. An engine may also be implemented as a combination of the two, with certain functions facilitated by hardware alone, and other functions facilitated by a combination of hardware and software. In an example, the software may reside in executable or non-executable form on a tangible machine-readable storage medium. Software residing in non-executable form may be compiled, translated, or otherwise converted to an executable form prior to, or during, runtime. In an example, the software, when executed by the underlying hardware of the engine, causes the hardware to perform the specified operations. Accordingly, an engine is physically constructed, or specifically configured (e.g., hardwired), or temporarily configured (e.g., programmed) to operate in a specified manner or to perform part or all of any operations described herein in connection with that engine.

Considering examples in which engines are temporarily configured, each of the engines may be instantiated at different moments in time. For example, where the engines comprise a general-purpose hardware processor core configured using software, the general-purpose hardware processor core may be configured as respective different engines at different times. Software may accordingly configure a hardware processor core, for example, to constitute a particular engine at one instance of time and to constitute a different engine at a different instance of time.

In certain implementations, at least a portion, and in some cases, all, of an engine may be executed on the processor(s) of one or more computers that execute an operating system, system programs, and application programs, while also implementing the engine using multitasking, multithreading, distributed (e.g., cluster, peer-peer, cloud, etc.) processing where appropriate, or other such techniques. Accordingly, each engine may be realized in a variety of suitable configurations, and should generally not be limited to any particular implementation exemplified herein, unless such limitations are expressly called out.

In addition, an engine may itself be composed of more than one sub-engines, each of which may be regarded as an engine in its own right. Moreover, in the embodiments described herein, each of the various engines corresponds to a defined functionality; however, it should be understood that in other contemplated embodiments, each functionality may be distributed to more than one engine. Likewise, in other contemplated embodiments, multiple defined functionalities may be implemented by a single engine that performs those multiple functions, possibly alongside other functions, or distributed differently among a set of engines than specifically illustrated in the examples herein.

System 900 includes a trained deep neural network (DNN) engine 902. The trained deep neural network 902 is constructed from at least one set of layers that perform staged operations on one or more inputs to produce an assessment at an output. Examples of a layered architecture are detailed in the following description. Briefly, the staged operations are performed based on predefined functions at each layer that have been specifically adapted by one or more training processes. These adaptations may be implemented as a sets of parameter values 903 representing weights, biases, filter attributes, or other variable settings that are specific to each of the layers, and effectively tune the computations that are performed by each respective layer.

In a deployed configuration, the trained deep neural network 902 operates in an inference mode in which feature maps are passed as inputs to successive layers along a forward propagation path in the trained deep neural network to be computationally processed at each layer to produce a corresponding layer output. Except for the final layer, each layer of the trained deep neural network 902 produces a feature-map as its output that is, in turn, passed to the next layer. The final layer produces an assessment 918 that may be a feature map, feature vector, or scalar value as the final output of the trained deep neural network 902.

### Inference Mode

In operation, measurement data 910 is supplied to system 900. Measurement data 910 may include data collected from individual material-processing operational instances as described in one or more of the embodiments above. Each material-processing operational instance of the measurement data 910 includes a work profile 912, which may be a force or pressure curve, for example, as an instance of response relationship 500 (Fig. 5), which may be computationally represented as a time-series vector, a 2-dimensional plot (e.g., x-y coordinates), a function, or an image (e.g., raster data), for example.

Each material-processing operational instance of the measurement data 910 may also include nominal geometry or operation type information 914 of the operational instance. The nominal geometry or operation type information 914 may be a single parameter, an index or code representing or pointing to a multi-parameter set of values, or a multi-dimensional value such as a vector representing the multiple parameter values themselves. For example, the nominal geometry or operation type information 914 may include or represent the hole diameter, the tooling associated with the operation (e.g., type of mandrel or sleeve, etc.), the material thickness of the workpiece, the construction of the workpiece (e.g., single or multilayer), the type of workpiece material, one or more tooling actuation parameters (e.g., speed), or other operational details.

Measurement data 910 may also include an instance identifier 916 of each corresponding material-processing operational instance of the measurement data 910, which may be used as a unique identifier of the hole, joint, or cold working site location. In some embodiments, the instance identifier 916 may be used as a primary key in a relational-database data structure that contains measurement data 910 and output set 920.

As shown, the work profile 912 and nominal geometry 914 of each material-processing operational instance of the measurement data 910 are provided as inputs to trained deep neural network 902. Trained deep neural network 902 processes these inputs through its layers in the forward propagation path, applying the sets of parameter values 903 accordingly, to produce assessment 918 that corresponds to the material-processing operational instance to which the work profile 912 and nominal geometry 914 correspond. Each individual assessment 918 is saved in output set data structure 920 in association with the corresponding instance identifier 916.

Each individual assessment 918 may represent a classification or measure of whether, or to what extent, the material-processing operational instance met its respective specification. Meeting of the specification may allow for some deviation from the ideal target according to predefined tolerance specifications. For example, the individual assessment 918 can differentiate between holes that were cold expanded within tolerance and holes that were out of tolerance in some way (e.g., hole oversize, thickness incorrect, mandrel over/undersize, incorrect sleeve).

### Training

In system 900, the sets of parameter values 903 that adapt each layer of the trained deep neural network 902 are supplied by training engine 904. Training engine 904 operates on deep neural network 902, or on a copy of deep neural network 902 having the same overall structure, to set the weights, biases, filter attributes, or other variable settings according to a training process. It will be understood that a deployed instance of trained deep neural network 902 may not have physically undergone a training process, but instead configured with the sets of parameter values 903 derived from actual training performed previously on a copy of the deep neural network 902. For ease of explanation, in the following discussion, no further distinction will be made between deep neural network 902 and any copy thereof that is subject to training.

During training, deep neural network 902 operates in a training mode, which includes testing and adjustment operations beyond the operations of the inference mode. In the training mode, deep neural network 902 processes pre-classified (i.e., labeled) training data 906 to produce a processing result. Training data 906 in this example includes known-good and known-bad values representing measured data from individual material-processing operational instances. Each material-processing operational instance of the training data 906 includes a work profile, and nominal geometry or operation type information of the operational instance, which are the same types of data as included in measurement data 910. In addition, each material-processing operational instance of the training data 906 includes a ground-truth indicator, such as an indication of whether the work profile is properly within specifications for the nominal geometry or operation type of the material-processing operational instance. The indicator may be binary (e.g., in-spec, out-of-spec), or it may be a measure or score, such as a ratio representing a degree of deviation from the ideal work profile associated with the nominal geometry or operation type.

During training, each item of training data 906 is fed instance-by-instance to the deep neural network 902 for processing along the forward propagation path. The assessment result of each item of training data 906 is compared against the ground truth corresponding to that item to produce a loss function that represents the error of the deep neural network's operation. The training process may use a backpropagation technique with gradient descent according to known training techniques or any suitable training technique, to adjust the sets of parameter values 903 in a way that tends to reduce or minimize the loss function for that item of training data. **In** general, the adjustments are made successively for each adjustable layer in a reverse propagation direction (opposite the forward propagation direction). The training process is repeated for each item of training data 906 to tune the deep neural network 902.

Following training, the trained deep neural network 902 may be tested using a set of pre-classified test data (not shown) that is similar to training data 906, except this data was not used to train the deep neural network 902. The testing may determine a performance measure of the trained deep neural network 902 from which a confidence score may be derived.

### Example Architecture of Deep neural network

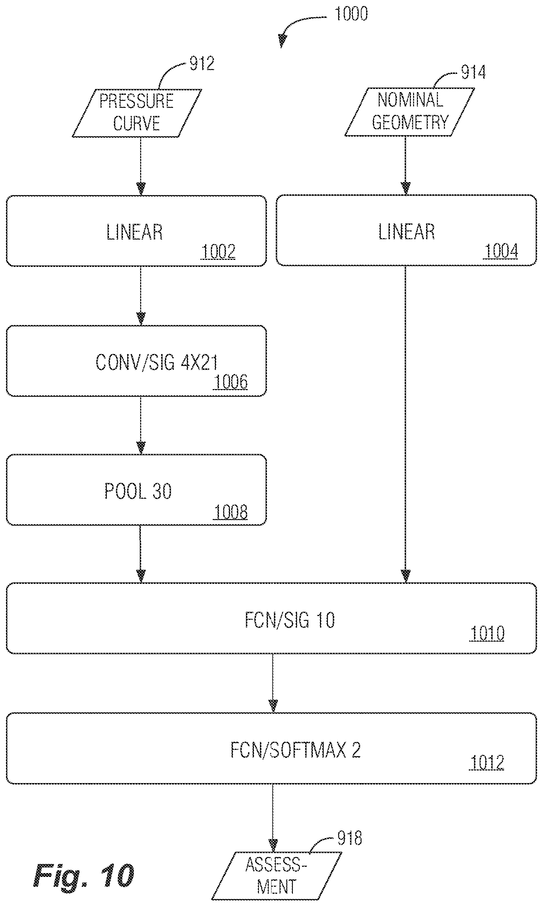

Fig. 10 is a diagram illustrating an example architecture 1000 of a deep neural network that may be used to implement trained deep neural network 902, for example. The inputs, work profile 912, and nominal geometry or operation type information 914, are directed to linear layers 1002 and 1004, respectively. Each linear layer 1002, 1004 facilitates weighting and biasing of the input to enhance certain features while suppressing other features of its respective input. The weights and biases of each linear layer 1002, 1004 are a subset of the sets of parameter values 903 in this example.

Linear layer 1002 outputs its feature map to convolutional and activation layer 1006. Convolutional and activation layer 1006 includes a convolution engine that applies a series of filters to its input feature map with a convolution operation. In the example shown, the convolution engine uses four filters of length 21 nodes each. The filters may be of various types, from among unrestricted, net-zero averaging, unity, and inverse-unity types. The filter selection and values may be adjusted as part of the training operations in some examples.

The convolution operation in layer 1006 is followed by an activation function. **In** this example the sigmoid function is used. However, in other embodiments another suitable function, such as tanh function, or a rectified linear unit (ReLU) function, a leaky ReLU, exponential linear unit (ELU), or the like, may be used.

The feature map that is output by convolution and activation layer 1006 is directed to pooling layer 1008. Pooling layer 1008 may be a max-pooling layer, for example. **In** the embodiment depicted, the pooling layer 1008 has a length of 30 nodes. Weighting and biasing may be applied as per an applicable portion of the sets of parameter values 903.

The feature map that is output by pooling layer 1008 is fed as the input to fully-connected and activation layer 1010. The output of linear layer 1004 is also directed to fully-connected and activation layer 1010. Accordingly, fully-connected and activation layer 1010 takes into account the nominal geometry or operation type adapted from information 914 at the corresponding input. Notably, this input bypasses the convolutional layer. In the example depicted, fully-connected and activation layer 1010 has a length of 10 nodes. Weighting and biasing may be applied as per an applicable portion of the sets of parameter values 903. The activation type may be a sigmoid function, as shown, or another suitable type of activation function.

The feature map at the output of layer 1010 is input to fully-connected and probability layer 1012. In the example shown, layer 1010 has a length of 2 nodes, and applies a softmax probability function. Weighting and biasing may be applied as per an applicable portion of the sets of parameter values 903. The result is assessment 918, as shown.

### Example Operation of a Deep neural network for use with Material-Processing Operations

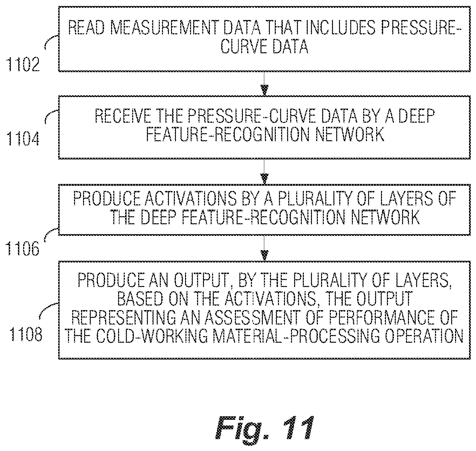

Fig. 11 is a flow diagram illustrating an example process of operation of a deep neural network for assessment of material-processing operations according to some embodiments. The process is automated and may be performed without human intervention, although it may be optionally initiated or interrupted by a human operator. At 1102, measurement data that includes pressure-curve data representing a cold-working material-processing operation is read by a processor-based computing platform. At 1104, a deep neural network having an input layer receives the measurement data at the input layer.

At 1106, the deep neural network operates by producing activations using its plurality of layers. The layers may include one or more linear layers, one or more convolutional layers, one or more activation layers, one or more pooling layers, one or more fully-connected layers, and one or more probabilistic layers. The activations are based on feature sets derived from the pressure-curve data. At 1108, the plurality of layers produce an output based on the activations. The output represents an assessment of performance of the cold-working material-processing operation.

In one embodiment, the output is a binary assessment of a performance of the cold-working material-processing operation indicating whether the operation meets specifications. In another embodiment, the output may be a measure of a performance of the cold-working material-processing operation indicating a degree to which the operation meets (or fails to meet) specifications.

### Example of Training a Deep neural network for use with Material-Processing Operations

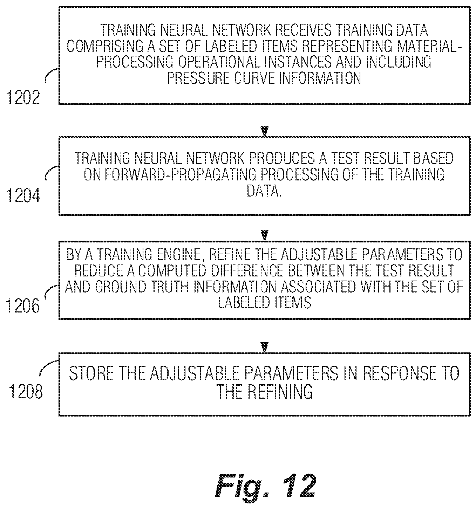

Fig. 12 is a flow diagram illustrating an example process of training a deep neural network for a use with material-processing operations according to some embodiments. At 1202, a training neural network structured similarly to a neural network to be deployed for inference operations receives training data. The training data includes a set of labeled items (including ground-truth information) representing material-processing operational instances, and includes work profile information.

At 1204, the training neural network produces a test result based on forward-propagating processing of the training data. The forward-propagating processing includes application of adjustable parameters to be refined. At 1206, a training engine refines the adjustable parameters to reduce a computed difference between the test result and ground truth information associated with the set of labeled items, in the training neural network.

At 1208, the adjustable parameters are stored in response to the refining. The process operations 1202-1208 may be iterated over a set of training data that preferably includes 100 or more material-processing operational instances to further refine the adjustable parameters. The refined adjustable parameters may be configured in a deployable deep neural network for use with material-processing operations.

### Machine Learning-Based Analytical System for Fatigue Life Prediction of Cold-Worked Sites

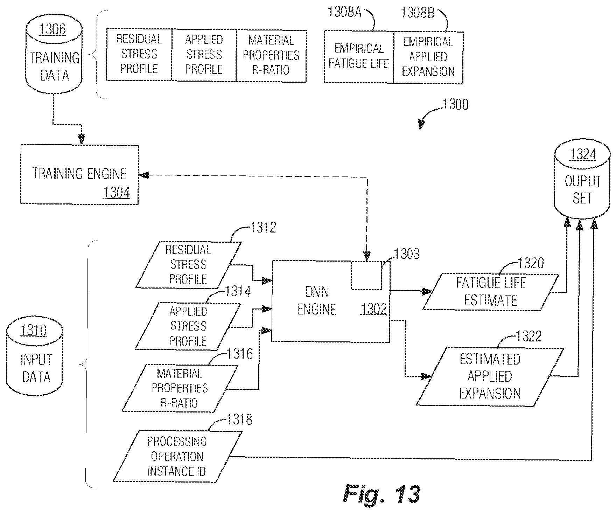

Fig. 13 is a system block diagram illustrating a machine-learning-based assessment system 1300 operative to predict fatigue life of materials having been cold-worked with material-processing operations, such as radial expansion cold working (e.g., Cx) operational instances, according to a related type of embodiment. As depicted, system 1300 includes a set of engines as will be described below.

System 1300 includes a trained deep neural network (DNN) engine 1302. The trained deep neural network 1302 is similar in principle to deep neural network 902 described above, although it may have a different architecture, as will be described in greater detail below. Accordingly, the staged operations are performed based on predefined functions at each layer that have been specifically adapted by one or more training processes similar to the training process described above with reference to Fig. 9. These adaptations may be implemented as a sets of parameter values 1303 representing weights, biases, filter attributes, or other variable settings.

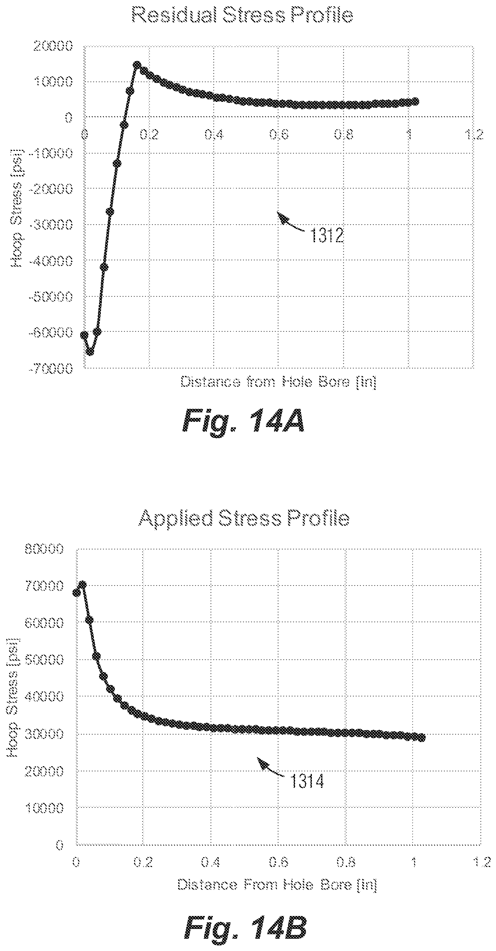

In operation, input data 1310 is supplied to system 1300. Input data 1310 may include residual stress profile information 1312, applied stress profile information 1314, and material properties data 1316. Residual stress profile information 1312 is specific to a subject site of a workpiece that was subject to cold working. For example, a residual stress profile may include measured hoop stress of material surrounding a formed hole as a function of distance from the hole bore. The residual stress profile may be measured by any suitable technique including (without limitation) neutron diffraction, electromagnetic measurement, X-ray measurement, ultrasonic measurement, or the like. Fig. 14A illustrates an example of a residual stress profile as a 2-dimensional plot. The values provided in Fig. 14A are for illustration only. As shown, the residual stress profile is presented as the hoop stress (in units of psi) versus the distance from the hole bore. The residual stress profile may be computationally represented in any suitable format (e.g., as a time-series vector, a 2-dimensional plot (e.g., x-y coordinates), a function, or an image (e.g., raster data), for example).

The applied stress profile information 1314 is also specific to the subject site of a workpiece that was subject to cold working. The applied stress (in terms of hoop stress) may be obtained during the material-processing operational instances using any of the measurement techniques mentioned above for measurement of the residual stress profile, or by another suitable technique. In one embodiment, tool-based sensors may be employed to measure applied force as described above, to obtain the response relationship 500 (Fig. 5), and the hoop stress representation may be computationally derived therefrom. Fig. 14B is a plot exemplifying an applied stress profile in terms of hoop stress versus distance from the hole bore. The values provided in Fig. 14B are for illustration only. The applied stress profile may be computationally represented in any suitable format (e.g., as a time-series vector, a 2-dimensional plot (e.g., x-y coordinates), a function, or an image (e.g., raster data), for example).

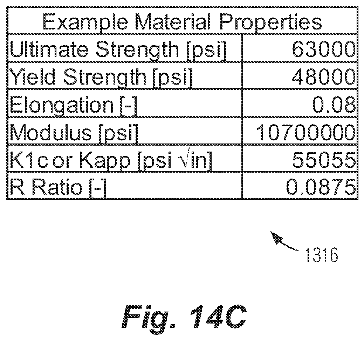

An example set of material properties data 1316 is shown in Fig. 14C. The types of properties that may be included in this set of data is ultimate strength, yield strength, elongation, modulus, fracture toughness (e.g., K1c), and R-ratio as a representation of fatigue properties. The values provided in Fig. 14C are for illustration only. The material properties data 1316 may be computationally represented as a vector or tuple of the set of values.

Input data 1310 may also include an instance identifier 1318 of each corresponding material-processing operational instance of the input data 1310, which may be used as a unique identifier of the hole, joint, or cold working site location. In some embodiments, the instance identifier 1318 may be used as a primary key in a relational-database data structure that contains input data 1310 and output data set 1324.

As shown, the residual stress profile data 1312, applied stress profile data 1314, and material properties data 1316 of each material-processing operational instance of the input data 1310 are provided as inputs to trained deep neural network 1302. Trained deep neural network 1302 processes these inputs through its layers in the forward propagation path, applying the sets of parameter values 1303 accordingly, to produce two outputs, fatigue life estimate 1320, and estimated applied expansion 1322. Each individual output 1320, 1322 is saved in output set data structure 1324 in association with the corresponding instance identifier 1318.

Fatigue life estimate 1320 may be represented as the base-10 logarithm of the fatigue life of the subject site of the workpiece. As an illustrative example, its value may fall in the range of 4 to 8. The estimated applied expansion 1322 may be ranked CW in the range of -2 to 2, with a value of 0 representing a properly cold-worked site, a value of -2 representing a non-expanded result (NCx), and a value of 2 representing a maximum expansion value up to the cracking threshold.

In system 1300, the sets of parameter values 1303 that adapt each layer of the trained deep neural network 1302 are supplied by training engine 1304. Training engine 1304 operates on deep neural network 1302, or on a copy of deep neural network 1302 having the same overall structure, to set the weights, biases, filter attributes, or other variable settings according to a training process, similar to the general arrangement of the examples described above with reference to Fig. 9.

During training, deep neural network 1302 operates in a training mode, which includes testing and adjustment operations beyond the operations of the inference mode. In the training mode, deep neural network 1302 processes pre-classified (i.e., labeled) training data 1306 to produce a processing result. Training data 1306 in this example includes data representing the residual stress profile, the applied stress profile, and the material properties data for individual material-processing operational instances and post-operation measurement. Items of training data 1306 are generally the same types of data as included in input data 1310. In addition, each item of training data 1306 includes a ground-truth indicator corresponding to the outputs, namely empirical fatigue life measure 1308A corresponding to fatigue life estimate 1320, and empirical applied expansion 1308B, corresponding to estimated applied expansion 1322. Each empirical measurement 1308 may be produced by direct or indirect testing of a corresponding workpiece sample.

During training, as discussed above with reference to Fig. 9, each item of training data 1306 is fed instance-by-instance to the deep neural network 1302 for processing along the forward propagation path. The assessment result of each item of training data 1306 is compared against the ground truth corresponding to that item to produce a loss function that represents the error of the deep neural network's operation. The training process may use a backpropagation technique with gradient descent according to known training techniques or any suitable training technique, to adjust the sets of parameter values 1303 in a way that tends to reduce or minimize the loss function for that item of training data.

Following training, the trained deep neural network 1302 may be tested using a set of pre-classified test data (not shown) that is similar to training data 1306, except this data was not used to train the deep neural network 1302. The testing may determine a performance measure of the trained deep neural network 1302 from which a confidence score may be derived.

### Example Architecture of Deep neural network for Estimating Fatigue Life

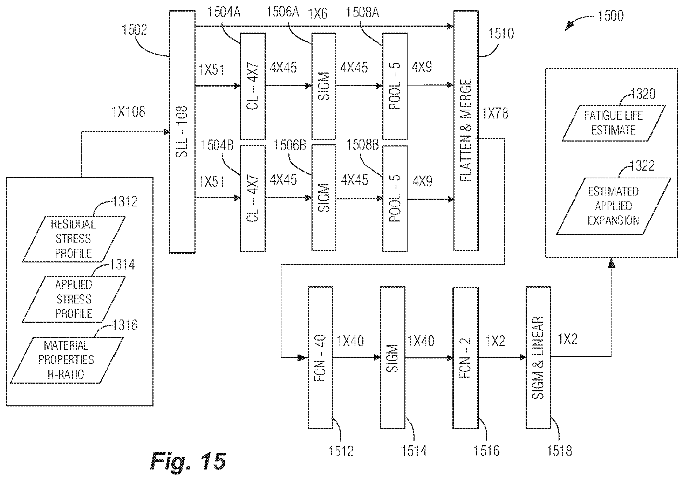

Fig. 15 is a diagram illustrating an example architecture 1500 of a deep neural network that may be used to implement trained deep neural network 1302, for example. The inputs, residual stress profile 1312, applied stress profile 1314, and material properties and R-ratio 1316, are directed to input linear layer SLL 1502. SLL layer 1502 facilitates weighting and biasing of the input to enhance certain features while suppressing other features of its respective inputs. The weights and biases of linear layer 1502 are a subset of the sets of parameter values 1303 in this example. In the example shown, the input SLL layer has a length of 108 nodes to accept residual stress profile 1312 of size 51 samples, concatenated with applied stress profile 1314 also having a size of 51 samples, further concatenated with the material properties and R-ratio 1316 having a size of 6 data points.

SLL layer 1502 splits its output three ways: the residual stress profile feature map is directed to convolutional layer 1504A, whereas the applied stress profile feature map is directed to convolutional layer 1504B. The material properties data 1316 are directed to flatten and merge layer 1510 to bypass the convolutional, activation, and pooling layers 1504-1508.

Convolutional layers 1504A, 1504B each includes a convolution engine that applies a series of filters to its input feature map with a convolution operation. In the example shown, the convolution engine uses four filters of length 7 nodes each, which are operated to produce four feature maps of length 45. The filters may be of various types, from among unrestricted, net-zero averaging, unity, and inverse-unity types. The filter selection and values may be adjusted as part of the training operations in some examples. Each convolutional layer 1504A, 1504B may have different filter values, weights and biases.

Activation layers 1506A and 1506B are fed respectively by convolutional layers 1504A and 1504B as shown. In this example the sigmoid function is used. However, in other embodiments another suitable function, such as tanh function, or a rectified linear unit (ReLU) function, a leaky ReLU, exponential linear unit (ELU), or the like, may be used. As shown, the activation layers 1506A and 1506B do not make a dimensional change.

The feature maps that are output by activation layers 1506 are directed to pooling layers 1508A and 1508B as shown. Pooling layers 1508 may be a max-pooling layer, for example. In the embodiment depicted, the pooling layer 1508 has a length of 5 nodes to produce reduce the length of the feature maps to 9 (still in 4 dimensions). Weighting and biasing may be applied as per an applicable portion of the sets of parameter values 1503.

The feature maps that are output by pooling layers 1508A, 1508B are fed as the input to flatten and merge layer 1510, which also receives the material properties and R-ratio-based feature map (having a length of 6) from SLL layer 1502. In the example depicted, flatten and merge layer 1510 has an output feature map length of 78 nodes in one dimension. Weighting and biasing may be applied as per an applicable portion of the sets of parameter values 1303.

The feature map at the output of layer 1510 is input to fully-connected layer 1512, having a length of 40 nodes. Weighting and biasing may be applied as per an applicable portion of the sets of parameter values 1303. The feature map at the output of layer 1512 is input to activation layer 1514, also having a length of 40 nodes, which applies a sigmoid or other suitable activation function. The feature map at the output of activation layer 1514 is input to fully-connected layer 1516, having a reduced length of 2 nodes. Weighting and biasing may be applied as per an applicable portion of the sets of parameter values 1303.

Finally, the feature map at the output of layer 1516 is input to activation and linear layer 1518, also having a length of 2 nodes, which applies a sigmoid or other suitable activation function. Weighting and biasing may be applied as per an applicable portion of the sets of parameter values 1303. The results are estimated fatigue life value 1320 and estimated applied expansion value 1322 as shown.

### Example Operation of a Deep neural network to Estimate Fatigue Life

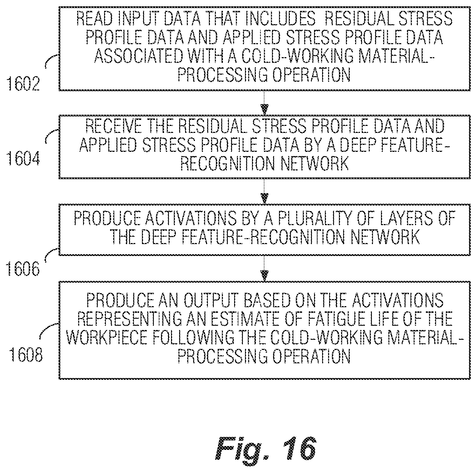

Fig. 16 is a flow diagram illustrating an example process of operation of a deep neural network for estimation of fatigue life of a workpiece following material-processing operations according to some embodiments. The process is automated and may be performed without human intervention, although it may be optionally initiated or interrupted by a human operator. At 1602, measurement data that includes residual stress profile data and applied stress profile data associated with a cold-working material-processing operation is read by a processor-based computing platform. At 1604, a deep neural network having an input layer receives the residual stress profile data and applied stress profile data at the input layer.

At 1606, the deep neural network operates by producing activations using its plurality of layers. The layers may include one or more linear layers, one or more convolutional layers, one or more activation layers, one or more pooling layers, and one or more fully-connected layers. The activations are based on feature sets derived from the residual stress profile data and applied stress profile data. At 1608, the plurality of layers produce an output based on the activations. The output represents an estimate of fatigue life of the workpiece following the cold-working material-processing operation. In a related embodiment, an additional output is produced based on the activations. The additional output represents an estimate of applied expansion of the cold-working material-processing operation.

In one embodiment, the output includes a numerical representation of a logarithm of the fatigue life estimate, having a value of between 4 and 8. The additional output may include a numerical representation of the estimate of applied expansion, having a value of between -2 and 2.

### Tree-Based Evaluation

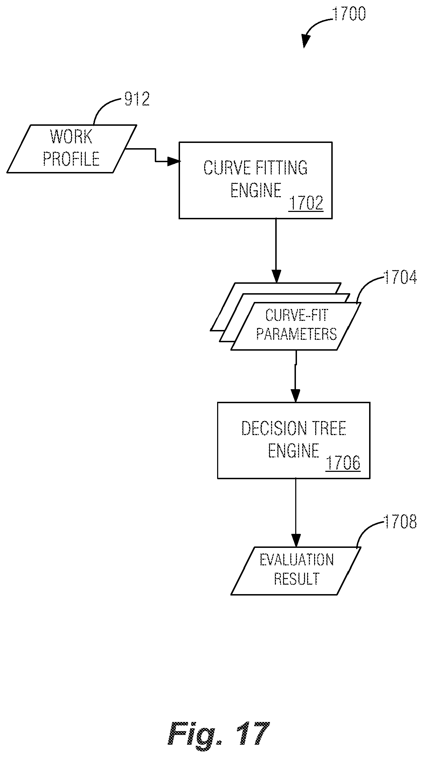

Fig. 17 is a system block diagram illustrating a machine-learning-based assessment system 1700 operative to evaluate received measurement data using a decision tree, according to another type of embodiment. System 1700 includes curve-fitting engine 1702, and trained decision tree engine 1706. In operation, curve-fitting engine 1702 receives, as its input, work profile 912 (discussed above with reference to FIG. 9). In general, work profile 912 represents a mechanical response over a displacement to a cold-working material-processing operation effecting the displacement by a target portion of a workpiece, as discussed above. For instance, it may include a measured force or pressure as a function of displacement of an actuator effecting the cold-working material-processing operation that includes cold expansion of a hole at the target portion of the workpiece to impart residual stress to the workpiece.

Curve-fitting engine 1702 produces, as its output, a set of values for curve-fit parameters 1704 that, collectively, represent a fit of the work profile 912 using a reference curve, such as a vertically offset skewed Gaussian curve. In this example, the amplitude, skew, and width of work profile 912 in achieving the curve fit are the various types of parameters constituting curve-fit parameters 1704.

The curve-fit parameters are provided as inputs to decision tree engine 1706. Decision tree engine 1706 may be a trained decision tree or trained regression tree (e.g., a classification and regression tree - CART) according to various embodiments. For the sake of brevity, the term "decision tree" will be used hereinafter to refer to any of various types of decision or regression trees, unless any particular distinction between the types is expressly called out.

Decision tree engine 1706 implements a decision tree constructed with a root node, which splits into branches, each branch optionally splitting into further branches, and ending at leaves. Each leaf represents a classification result. Each branch of the decision tree is constructed based on selected features and corresponding conditions that determine the respective directions of the splits at the branches. In the present example, the branches are based on selected values of the amplitude, skew, and width parameters, which are predetermined according to a training operation.

Decision tree engine 1706 produces, as its output, evaluation result 1708, which may be a classification or prediction. In various implementations, evaluation result 1708 may be a binary classification (i.e., into one of two categories) or a classification into one of multiple categories. In related implementations, evaluation result 1708 may be a representation of linear or non-linear relationships between predictors and response.

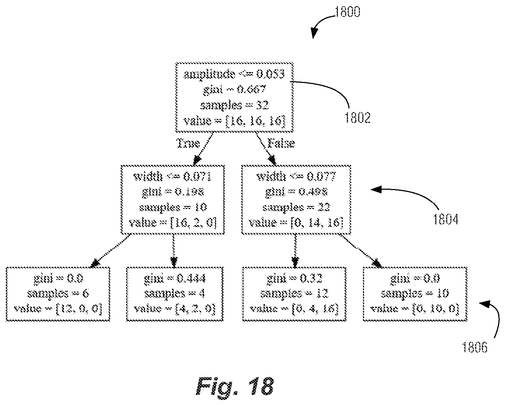

FIG. 18 is a diagram illustrating an example decision tree classifier 1800 that may be implemented by decision tree engine 1706 in one embodiment. As illustrated, root node 1802 applies an amplitude-based condition to split into branch nodes 1804, which in turn apply a width-based condition to classify the input values according to leaves 1806.

In related embodiments, decision tree engine 1706 may implement a variety of decision trees, corresponding to different workpiece properties, such as material thickness, different workpiece material compositions, different hole sizes, and other attributes of the various material-processing or analysis applications.

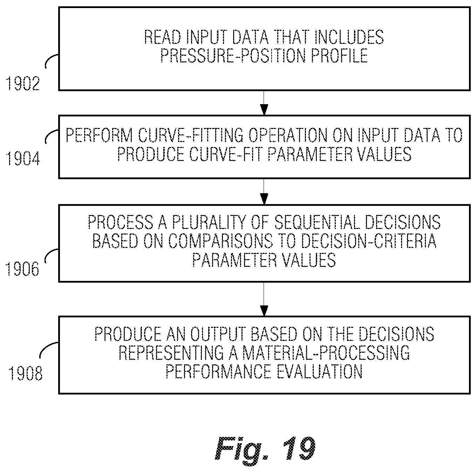

FIG. 19 is a process flow diagram illustrating an example process of operation 1900 of a tree-based evaluation system according to some embodiments. The process may be carried out by system 1700, for example. At 1902, input data is read. The input data may include a pressure-position profile produced by measurements of a material-processing operation.

At 1904, a curve-fitting operation is performed on the input data. The curve-fitting operation produces curve-fit parameter values. For example, the parameters may include amplitude, width, and skew to achieve a Gaussian curve-fitting operation of the input data.

At 1906, a plurality of sequential decisions are processed by a decision tree engine that involve comparison of the curve-fit parameter values to decision criteria parameter values. For example, a first decision may be made based on whether the curve-fit amplitude is greater or less than an amplitude-based criteria value. A second sequential decision may be made based on the width parameter; a third sequential decision may be based on the skew parameter, etc.

At 1908, an output based on the sequence of decisions by the decision tree engine is produced. The output may represent a material-processing performance evaluation for any one (or more) of the material processing operations discussed above, or another material-processing operation. For example, the material-processing performance evaluation may indicate whether or not a material-processing operation meets one or more specifications. In another example, material-processing performance evaluation may indicate a degree to which the operation meets specifications.

## Claims

1. An autonomous method for assessment of material-processing operations, the method comprising:
receiving, by an input layer of a deep feature-recognition network, measurement data comprising a work-profile data set representing a mechanical response over a displacement to a cold-working material-processing operation effecting the displacement, by a target portion of a workpiece;
producing activations of nodes of a plurality of additional layers of the deep feature-recognition network based on feature sets derived from the measurement data; and
producing an output based on the activations, the output representing an assessment of performance of the cold-working material-processing operation;
wherein the deep feature-recognition network is tuned by a set of adjustable parameters derived from a training process wherein:
training data, (906) comprising a set of labeled items representing preview material-processing operation instances and including respective work-profile data sets, is input to a training neural network, wherein the training neural network produces a test result based on forward-propagating processing of the training data, wherein the forward-propagating processing includes application of the adjustable parameters by the training neural network;
the adjustable parameters are refined to reduce a computed difference between the test result and ground truth information associated with the set of labeled items; and
the refined adjustable parameters are supplied to tune the deep feature-recognition network.

2. The method of claim 1, wherein the receiving and producing operations are performed autonomously by a specially-programmed computer system.

3. The method according to any preceding claim, wherein the work-profile data set includes a measured force or pressure as a function of displacement of an actuator effecting the cold-working material-processing operation that includes cold expansion of a hole at the target portion of the workpiece to impart residual stress to the workpiece.

4. The method of claim 3, further comprising:
operating the actuator to effect the cold-working material-processing operation, and measuring the force or pressure as a function of the displacement of the actuator.

5. The method of claim 4, further comprising:
sensing at least one of a pressure, a position of the actuator, a distance of travel of the actuator, or a reaction force resulting from a force applied directly or indirectly by the cold-working material-processing operation; and
producing the work-profile data set based on the sensing.

6. The method according to any preceding claim, wherein the measurement data includes nominal geometry or operation type information of the cold-working material-processing operation.

7. The method of claim 6, wherein the nominal geometry or operation type information includes at least one data type selected from the group consisting of: a hole diameter, type of tooling associated with the cold-working material-processing operation, a material thickness of a workpiece, construction of the workpiece, a type of workpiece material, a tooling actuation parameters, or any combination thereof.

8. The method according to any preceding claim, wherein the output is a binary assessment of a performance of the cold-working material-processing operation indicating whether the operation meets specifications.

9. The method according to any preceding claim, wherein the output is a measure of a performance of the cold-working material-processing operation indicating a degree to which the operation meets specifications.

10. At least one non-transitory machine-readable storage medium containing instructions that, when executed by a computer system, cause the computer system to execute operations to implement the method according to any one of claims 1-9.

11. A deep feature-recognition network for assessment of material-processing operations, the deep feature-recognition network including a training engine (904); and a training neural network; and
a deep feature-recognition network engine including a multilayer architecture comprising:
an input layer that includes a plurality of nodes operative to receive measurement data comprising a work-profile data set representing a mechanical response over a displacement to a cold-working material-processing operation effecting the displacement, by a target portion of a workpiece;
a plurality of additional layers that are operative to produce activations of nodes based on feature sets derived from the measurement data;
the deep feature-recognition network being further configured to produce an output based on the activations, the output representing an assessment of performance of the cold-working material-processing operation; and
wherein the deep feature-recognition network is trained by:
receiving training data by a target portion of a workpiece by the training neural network, the training data comprising a set of labeled items representing material-processing operational instances and including measurement data comprising a work-profile data set representing a mechanical response over a displacement to a cold-working material-processing operation effecting the displacement;
producing, by the training neural network, a test result based on forward-propagating processing of the training data, wherein the forward-propagating processing includes application of adjustable parameters;
by the training engine, refining the adjustable parameters to reduce a computed difference between the test result and ground truth information associated with the set of labeled items; and
the deep feature-recognition network engine further configured to store the adjustable parameters, and wherein the deep feature-recognition network is configured to be tuned by the refined adjustable parameters.

12. The deep feature-recognition network according to claim 11, further comprising:
a computer system, including processor and input/output circuitry, and at least one data-storage device containing instructions that, when executed on the computer system, cause the computer system to implement a first deep feature-recognition network engine.

13. A system comprising:
the deep feature-recognition network according to claim 11, wherein the input layer of the deep feature-recognition network engine is communicatively coupled to a controller of a material-processing tool operative to effect the cold-working material-processing operation.

## Patentansprüche

1. Ein autonomes Verfahren zur Bewertung von Materialbearbeitungsoperationen, wobei das Verfahren Folgendes beinhaltet:
Empfangen, durch eine Eingangsschicht eines tiefen Merkmalserkennungsnetzwerks, von Messdaten, die einen Arbeitsprofildatensatz beinhalten, der eine mechanische Reaktion über einer Verschiebung auf eine Kaltumformungs-
Materialbearbeitungsoperation, die die Verschiebung bewirkt, durch einen Zielabschnitt eines Werkstücks darstellt;
Produzieren von Aktivierungen von Knoten einer Vielzahl von zusätzlichen Schichten des tiefen Merkmalserkennungsnetzwerks auf der Basis von Merkmalssätzen, die aus den Messdaten abgeleitet sind; und
Produzieren einer Ausgabe auf der Basis der Aktivierungen, wobei die Ausgabe eine Bewertung der Leistung der Kaltumformungs-Materialbearbeitungsoperation darstellt;
wobei das tiefe Merkmalserkennungsnetzwerk durch einen Satz einstellbarer Parameter angepasst wird, die aus einem Trainingsprozess abgeleitet sind, wobei:
Trainingsdaten (906), die einen Satz markierter Elemente beinhalten, die Vorschau-Materialbearbeitungsoperationsinstanzen darstellen, und jeweilige Arbeitsprofildatensätze umfassen, in ein neuronales Trainingsnetzwerk eingegeben werden, wobei das neuronale Trainingsnetzwerk ein Testergebnis auf der Basis von Vorwärtspropagierungsverarbeitung der Trainingsdaten produziert, wobei die Vorwärtspropagierungsverarbeitung die Anwendung der einstellbaren Parameter durch das neuronale Trainingsnetzwerk umfasst;
die einstellbaren Parameter verfeinert werden, um eine berechnete Differenz zwischen dem Testergebnis und Ground-Truth-Informationen, die mit dem Satz markierter Elemente assoziiert sind, zu reduzieren; und
die verfeinerten einstellbaren Parameter bereitgestellt werden, um das tiefe Merkmalserkennungsnetzwerk anzupassen.

2. Verfahren gemäß Anspruch 1, wobei die Empfangs- und Produktionsoperationen autonom durch ein speziell programmiertes Computersystem durchgeführt werden.

3. Verfahren gemäß einem vorhergehenden Anspruch, wobei der Arbeitsprofildatensatz eine gemessene Kraft oder einen gemessenen Druck als eine Funktion der Verschiebung eines Aktors umfasst, der die Kaltumformungs-Materialbearbeitungsoperation bewirkt, die eine Kaltexpansion eines Lochs an dem Zielabschnitt des Werkstücks umfasst, um dem Werkstück Restspannung zu verleihen.

4. Verfahren gemäß Anspruch 3, das ferner Folgendes beinhaltet:
Betreiben des Aktors, um die Kaltumformungs-Materialbearbeitungsoperation zu bewirken, und Messen der Kraft oder des Drucks als eine Funktion der Verschiebung des Aktors.

5. Verfahren gemäß Anspruch 4, das ferner Folgendes beinhaltet:
Erfassen von mindestens einem von einem Druck, einer Position des Aktors, einer Bewegungsstrecke des Aktors oder einer Reaktionskraft, die aus einer Kraft resultiert, die direkt oder indirekt durch die Kaltumformungs-Materialbearbeitungsoperation ausgeübt wird; und
Produzieren des Arbeitsprofildatensatzes auf der Basis des Erfassens.

6. Verfahren gemäß einem vorhergehenden Anspruch, wobei die Messdaten Nenngeometrie- oder Operationstypinformationen der Kaltumformungs-Materialbearbeitungsoperation umfassen.

7. Verfahren gemäß Anspruch 6, wobei die Nenngeometrie- oder Operationstypinformationen mindestens einen Datentyp umfassen, der aus der Gruppe ausgewählt ist, die aus Folgendem besteht: einem Lochdurchmesser, einem Werkzeugtyp, der mit der Kaltumformungs-Materialbearbeitungsoperation assoziiert ist, einer Materialdicke eines Werkstücks, einer Konstruktion des Werkstücks, einem Typ von Werkstückmaterial, Werkzeugbetätigungsparametern oder einer beliebigen Kombination davon.

8. Verfahren gemäß einem vorhergehenden Anspruch, wobei die Ausgabe eine binäre Bewertung einer Leistung der Kaltumformungs-Materialbearbeitungsoperation ist, die angibt, ob die Operation Spezifikationen erfüllt.

9. Verfahren gemäß einem vorhergehenden Anspruch, wobei die Ausgabe ein Maß einer Leistung der Kaltumformungs-Materialbearbeitungsoperation ist, das einen Grad angibt, in dem die Operation Spezifikationen erfüllt.

10. Mindestens ein nichtflüchtiges maschinenlesbares Speichermedium, das Anweisungen enthält, die, wenn sie durch ein Computersystem ausgeführt werden, das Computersystem veranlassen, Operationen auszuführen, um das Verfahren gemäß einem der Ansprüche 1-9 zu implementieren.

11. Ein tiefes Merkmalserkennungsnetzwerk zur Bewertung von
Materialbearbeitungsoperationen, wobei das tiefe Merkmalserkennungsnetzwerk eine Trainingsmaschine (904) und ein neuronales Trainingsnetzwerk umfasst; und wobei eine Maschine des tiefen Merkmalserkennungsnetzwerks eine mehrschichtige Architektur umfasst, die Folgendes beinhaltet:
eine Eingangsschicht, die eine Vielzahl von Knoten umfasst, die betriebsfähig sind, um Messdaten zu empfangen, die einen Arbeitsprofildatensatz beinhalten, der eine mechanische Reaktion über einer Verschiebung auf eine Kaltumformungs-Materialbearbeitungsoperation, die die Verschiebung bewirkt, durch einen Zielabschnitt eines Werkstücks darstellt;
eine Vielzahl von zusätzlichen Schichten, die betriebsfähig sind, um Aktivierungen von Knoten auf der Basis von aus den Messdaten abgeleiteten Merkmalssätzen zu produzieren;
wobei das tiefe Merkmalserkennungsnetzwerk ferner konfiguriert ist, um auf der Basis der Aktivierungen eine Ausgabe zu produzieren, wobei die Ausgabe eine Bewertung der Leistung der Kaltumformungs-Materialbearbeitungsoperation darstellt; und
wobei das tiefe Merkmalserkennungsnetzwerk trainiert wird durch:
Empfangen von Trainingsdaten durch einen Zielabschnitt eines Werkstücks durch das neuronale Trainingsnetzwerk, wobei die Trainingsdaten einen Satz markierter Elemente beinhalten, die Materialbearbeitungsoperationsinstanzen darstellen, und Messdaten umfassen, die einen Arbeitsprofildatensatz beinhalten, der eine mechanische Reaktion über einer Verschiebung auf eine Kaltumformungs-Materialbearbeitungsoperation, die die Verschiebung bewirkt, darstellt;
Produzieren, durch das neuronale Trainingsnetzwerk, eines Testergebnisses auf der Basis von Vorwärtspropagierungsverarbeitung der Trainingsdaten, wobei die Vorwärtspropagierungsverarbeitung die Anwendung einstellbarer Parameter umfasst; durch die Trainingsmaschine, Verfeinern der einstellbaren Parameter, um eine berechnete Differenz zwischen dem Testergebnis und Ground-Truth-Informationen, die mit dem Satz markierter Elemente assoziiert sind, zu reduzieren; und
wobei die Maschine des tiefen Merkmalserkennungsnetzwerks ferner konfiguriert ist, um die einstellbaren Parameter zu speichern, und wobei das tiefe Merkmalserkennungsnetzwerk konfiguriert ist, um durch die verfeinerten einstellbaren Parameter angepasst zu werden.

12. Tiefes Merkmalserkennungsnetzwerk gemäß Anspruch 11, das ferner Folgendes beinhaltet:
ein Computersystem, das einen Prozessor und Eingangs-/Ausgangsschaltungen umfasst, und mindestens eine Datenspeichervorrichtung, die Anweisungen enthält, die, wenn sie auf dem Computersystem ausgeführt werden, das Computersystem veranlassen, eine erste Maschine des tiefen Merkmalserkennungsnetzwerks zu implementieren.

13. Ein System, das Folgendes beinhaltet:
das tiefe Merkmalserkennungsnetzwerk gemäß Anspruch 11, wobei die Eingangsschicht der Maschine des tiefen Merkmalserkennungsnetzwerks kommunikativ mit einer Steuereinrichtung eines Materialbearbeitungswerkzeugs gekoppelt ist, das betriebsfähig ist, um die Kaltumformungs-Materialbearbeitungsoperation zu bewirken.

## Revendications

1. Un procédé autonome pour l'évaluation d'opérations de traitement de matériau, le procédé comprenant :
la réception, par une couche d'entrée d'un réseau de reconnaissance de caractéristiques profond, de données de mesure comprenant un ensemble de données de profil de travail représentant une réponse mécanique sur un déplacement à une opération de traitement de matériau par travail à froid effectuant le déplacement, par une portion cible d'une pièce à travailler ;
la production d'activations de nœuds d'une pluralité de couches supplémentaires du réseau de reconnaissance de caractéristiques profond sur la base d'ensembles de caractéristiques dérivés des données de mesure ; et
la production d'une sortie sur la base des activations, la sortie représentant une évaluation de performance de l'opération de traitement de matériau par travail à froid ; où le réseau de reconnaissance de caractéristiques profond est accordé par un ensemble de paramètres ajustables dérivés d'un processus d'entraînement où :
des données d'entraînement (906), comprenant un ensemble d'éléments étiquetés représentant des instances d'opération de traitement de matériau pour prévisualisation et incluant des ensembles de données de profil de travail respectifs, sont entrées dans un réseau neuronal d'entraînement, où le réseau neuronal d'entraînement produit un résultat de test sur la base d'un traitement par propagation avant des données d'entraînement, où le traitement par propagation avant inclut l'application des paramètres ajustables par le réseau neuronal d'entraînement ;
les paramètres ajustables sont affinés pour réduire une différence calculée entre le résultat de test et des informations de vérité de terrain associées à l'ensemble d'éléments étiquetés ; et
les paramètres ajustables affinés sont fournis pour accorder le réseau de reconnaissance de caractéristiques profond.

2. Le procédé de la revendication 1, où les opérations de réception et de production sont réalisées de manière autonome par un système informatique spécialement programmé.

3. Le procédé selon n'importe quelle revendication précédente, où l'ensemble de données de profil de travail inclut une force ou pression mesurée en fonction d'un déplacement d'un actionneur effectuant l'opération de traitement de matériau par travail à froid qui inclut une expansion à froid d'un trou au niveau de la portion cible de la pièce à travailler pour communiquer une contrainte résiduelle à la pièce à travailler.

4. Le procédé de la revendication 3, comprenant en outre :
la mise en action de l'actionneur pour effectuer l'opération de traitement de matériau par travail à froid, et la mesure de la force ou pression en fonction du déplacement de l'actionneur.

5. Le procédé de la revendication 4, comprenant en outre :
le captage d'au moins un élément parmi une pression, une position de l'actionneur, une distance de progression de l'actionneur, ou une force de réaction résultant d'une force appliquée directement ou indirectement par l'opération de traitement de matériau par travail à froid ; et
la production de l'ensemble de données de profil de travail sur la base du captage.

6. Le procédé selon n'importe quelle revendication précédente, où les données de mesure incluent des informations de géométrie nominale ou de type d'opération de l'opération de traitement de matériau par travail à froid.

7. Le procédé de la revendication 6, où les informations de géométrie nominale ou de type d'opération incluent au moins un type de données sélectionné dans le groupe constitué par : un diamètre de trou, un type d'outillage associé à l'opération de traitement de matériau par travail à froid, une épaisseur de matériau d'une pièce à travailler, une construction de la pièce à travailler, un type de matériau de pièce à travailler, des paramètres d'actionnement d'outillage, ou n'importe quelle combinaison de ceux-ci.

8. Le procédé selon n'importe quelle revendication précédente, où la sortie est une évaluation binaire d'une performance de l'opération de traitement de matériau par travail à froid indiquant si l'opération satisfait à des spécifications.

9. Le procédé selon n'importe quelle revendication précédente, où la sortie est une mesure d'une performance de l'opération de traitement de matériau par travail à froid indiquant un degré auquel l'opération satisfait à des spécifications.

10. Au moins un support de stockage lisible par machine non transitoire contenant des instructions qui, lorsqu'elles sont exécutées par un système informatique, amènent le système informatique à exécuter des opérations pour mettre en œuvre le procédé selon n'importe laquelle des revendications 1 à 9.

11. Un réseau de reconnaissance de caractéristiques profond pour l'évaluation d'opérations de traitement de matériau, le réseau de reconnaissance de caractéristiques profond incluant un moteur d'entraînement (904) ; et un réseau neuronal d'entraînement ; et
un moteur de réseau de reconnaissance de caractéristiques profond incluant une architecture multicouche comprenant :
une couche d'entrée qui inclut une pluralité de nœuds opérationnels pour recevoir des données de mesure comprenant un ensemble de données de profil de travail représentant une réponse mécanique sur un déplacement à une opération de traitement de matériau par travail à froid effectuant le déplacement, par une portion cible d'une pièce à travailler ;
une pluralité de couches supplémentaires qui sont opérationnelles pour produire des activations de nœuds sur la base d'ensembles de caractéristiques dérivés des données de mesure ;
le réseau de reconnaissance de caractéristiques profond étant en outre configuré pour produire une sortie sur la base des activations, la sortie représentant une évaluation de performance de l'opération de traitement de matériau par travail à froid ; et
où le réseau de reconnaissance de caractéristiques profond est entraîné par :
la réception de données d'entraînement par une portion cible d'une pièce à travailler par le réseau neuronal d'entraînement, les données d'entraînement comprenant un ensemble d'éléments étiquetés représentant des instances opérationnelles de traitement de matériau et incluant des données de mesure comprenant un ensemble de données de profil de travail représentant une réponse mécanique sur un déplacement à une opération de traitement de matériau par travail à froid effectuant le déplacement ;
la production, par le réseau neuronal d'entraînement, d'un résultat de test sur la base d'un traitement par propagation avant des données d'entraînement, où le traitement par propagation avant inclut l'application de paramètres ajustables ;
par le moteur d'entraînement, l'affinage des paramètres ajustables pour réduire une différence calculée entre le résultat de test et des informations de vérité de terrain associées à l'ensemble d'éléments étiquetés ; et
le moteur de réseau de reconnaissance de caractéristiques profond étant en outre configuré pour stocker les paramètres ajustables, et où le réseau de reconnaissance de caractéristiques profond est configuré pour être accordé par les paramètres ajustables affinés.

12. Le réseau de reconnaissance de caractéristiques profond selon la revendication 11, comprenant en outre :
un système informatique, incluant un processeur et une circuiterie d'entrée/sortie, et au moins un dispositif de stockage de données contenant des instructions qui, lorsqu'elles sont exécutées sur le système informatique, amènent le système informatique à mettre en œuvre un premier moteur de réseau de reconnaissance de caractéristiques profond.

13. Un système comprenant :
le réseau de reconnaissance de caractéristiques profond selon la revendication 11, où la couche d'entrée du moteur de réseau de reconnaissance de caractéristiques profond est couplée en communication à un contrôleur d'un outil de traitement de matériau opérationnel pour effectuer l'opération de traitement de matériau par travail à froid.
